(19) Europäisches Patentamt
European Patent Office
Office européen des brevets

(11) EP 0 946 459 B1

(12) EUROPÄISCHE PATENTSCHRIFT

(45) Veröffentlichungstag und Bekanntmachung des Hinweises auf die Patenterteilung:
**09.08.2000 Patentblatt 2000/32**

(21) Anmeldenummer: **97948732.9**

(22) Anmeldetag: **07.11.1997**

(51) Int Cl.$^7$: **C04B 35/80**

(86) Internationale Anmeldenummer:
**PCT/DE97/02597**

(87) Internationale Veröffentlichungsnummer:
**WO 98/21163 (22.05.1998 Gazette 1998/20)**

(54) **VERFAHREN ZUR CHEMISCHEN GASPHASENINFILTRATION VON REFRAKTÄREN STOFFEN, INSBESONDERE KOHLENSTOFF UND SILICIUMCARBID**

METHOD FOR CHEMICAL VAPOUR INFILTRATION OF REFRACTORY SUBSTANCES, ESPECIALLY CARBON AND SILICON CARBIDE

PROCEDE D'INFILTRATION CHIMIQUE EN PHASE VAPEUR DE MATIERES REFRACTAIRES, NOTAMMENT DE CARBONE ET DE CARBURE DE SILICIUM

(84) Benannte Vertragsstaaten:
**AT BE CH DE DK ES FR GB IT LI NL SE**

(30) Priorität: **08.11.1996 DE 19646094**

(43) Veröffentlichungstag der Anmeldung:
**06.10.1999 Patentblatt 1999/40**

(73) Patentinhaber: **Sintec Keramik GmbH & Co. KG.
87642 Buching (DE)**

(72) Erfinder:
- **HÜTTINGER, Klaus, J.
D-76227 Karlsruhe (DE)**
- **BENZINGER, Walther
D-67271 Neuleiningen (DE)**

(74) Vertreter: **Viering, Jentschura & Partner
Postfach 22 14 43
80504 München (DE)**

(56) Entgegenhaltungen:
**WO-A-95/11868 WO-A-96/32360**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 0 946 459 B1

Printed by Jouve, 75001 PARIS (FR)

## Beschreibung

Die Erfindung betrifft ein Verfahren zur chemischen Gasphaseninfiltration von refraktären Stoffen, insbesondere Kohlenstoff und Siliciumcarbid.

Verfahren zur Abscheidung von festen Phasen auf Substraten durch Zersetzung von flüchtigen oder gasförmigen Verbindungen, die Elemente der festen Phase enthalten, werden als chemische Gasphasenabscheidung bezeichnet. Erfolgt diese Abscheidung in offenen Poren eines porösen Substrates bzw. in den Hohlräumen einer porösen Struktur, so spricht man von chemischer Gasphaseninfiltration. Die chemische Gasphasenabscheidung (CVD; chemical vapor deposition) und die chemische Gasphaseninfiltration (CVI; chemical vapor infiltration) sind vor allem hinsichtlich der Abscheidung bzw. Infiltration refraktärer Materialien wie von Kohlenstoff, Carbiden, Nitriden, Boriden, Oxiden u. a. von Bedeutung (z.B. W.J. Lackey, in Encyclopedia of Composites, Vol. 1, edited by Stuart M. Lee, VCH Publishers, Inc., New York, 1990, S. 319). CVI-Verfahren erlauben eine Verdichtung der Struktur oder, wenn die poröse Struktur aus Fasern besteht, das Einbringen einer Matrix und damit die Herstellung von faserverstärkten Verbundwerkstoffen.

Sowohl die chemische Gasphasenabscheidung als auch die chemische Gasphaseninfiltration sind extrem komplexe Prozesse. Bei der chemischen Gasphasenabscheidung von Verbindungen wie z.B. Siliciumcarbid besteht ein Problem darin, es zu erreichen, daß die Abscheidung der festen Phase in stöchiometrischer Zusammensetzung erfolgt, bei größeren zu beschichtenden Bauteilen allgemein in der Generierung einer gleichmäßigen Schichtdicke.

Bei der chemischen Gasphaseninfiltration besteht ein weiteres Problem darin, daß die flüchtigen bzw. gasförmigen Ausgangsverbindungen vor ihrer Zersetzung in die Tiefe der Poren transportiert werden müssen. Erfolgt die Zersetzung bereits an der Oberfläche der porösen Struktur oder an den Poreneingängen, so kommt es zum Porenverschluß. Die Poren werden nicht ausgefüllt, was das eigentliche Ziel des Prozesses ist.

Bekannt sind unterschiedliche Ausführungsformen von Verfahren der chemischen Gasphaseninviltration (chemical infiltration, CVI).

Verfahrenstechnisch am einfachsten durchführbar sind Verfahren der isobaren, isothermen chemische Gasphaseninfiltration. Bei dieser Verfahrensweise befindet sich der gesamte Prozeßraum auf gleicher Temperatur und gleichem Druck. Es lassen sich jedoch nur sehr kleine Drücke bzw. Partialdrücke der Eduktgase, ggf. unter Zugabe von Inert- bzw. Verdünnungsgasen verwenden, so daß extrem lange Infiltrationszeiten benötigt werden.

Um die Infiltrationszeit zu verkürzen, wird gemäß der WO 95/16803 für die chemische Gasphaseninfiltration von Siliciumcarbid unter Verwendung von Methyltrichlorsilan (MTS) als Eduktgas vorgeschlagen, das Eduktgas auf Temperaturen weit oberhalb der Zersetzungstemperatur von MTS, d.h. auf 960°C bis 1050°C vorzuheizen, dabei Drükke von bis zu 25 kPa einzustellen und am Ausgang der Reaktionszone Silikatbestandteile aus der Gasphase abzuführen. Ein Vorheizen des MTS auf derart hohe Temperaturen führt zu einer großen Abscheidungsrate der mit dem Gas zugeführten Stoffe, wodurch eine große Fertigungsgeschwindigkeit erzielt wird, jedoch gleichzeitig zu einer ungleichmäßigen Ablagerung, insbesondere an der Oberfläche, und dadurch zu kleinen Porenfüllungsgraden.

Eine optimale bzw. maximale Porenfüllung gelingt daher nur bei extrem kleinen Abscheide- bzw. Infiltrationsgeschwindigkeiten (z.B. W.V. Kotlensky, in Chemistry and Physics of Carbon, Vol. 9, edited by P.L. Walker and P.A. Thrower, Marcel Dekker, New York, 1973, S. 173).

Zu deren Realisierung werden für die Infiltration kleine Drücke und insbesondere kleine Partialdrücke empfohlen. Die unter Bedingungen der industriell angewandten chemischen Gasphaseninfiltration realisierten Drücke liegen um mindestens eine bis zwei Größenordnungen unter Normaldruck. Teilweise werden den Ausgangsverbindungen Inertgase zugemischt, so daß sich deren Partialdruck und damit die Abscheidegeschwindigkeit weiter erniedrigt. Wegen der geringen Partialdrücke sind extrem lange Infiltrationszeiten bis zu einigen Wochen erforderlich.

Da es mit den isobaren und isothermen Verfahren nicht gelungen ist, eine schnelle Herstellung bzw. hohe Porenfüllungsgrade zu erreichen, hat man versucht, Verfahren mit kürzeren Infiltrationszeiten zu entwickeln, die als Druckgradienten-, Temperaturgradienten- und Druckwechselverfahren bezeichnet werden. Solche Verfahren sind z. B. aus Nyan-Hwa Tai and Tsu-Wei Chou, Journal of American Ceramic Society 73, 1489 (1990) bekannt.

Bei der Vakuum-Druck-Pulsations-Methode wird zur Unterstützung der Diffusion kontinuierlich der Prozeßdruck variiert. Der Nachteil dieser Methode liegt im hohen apparativen Aufwand und den immer noch sehr langen Filtrationszeiten.

Ein anderes bekanntes Verfahren ist die Temperaturgradienten-Methode (z.B. US-5,411,763, US-5,348,774). Dabei wird der dem Prozeßgasstrom zugewandten Seite des porösen Substrats durch geeignete Maßnahmen, z.B. Kühlung durch den Strom, Wärme entzogen. Die dem Gasstrom abgewandte Seite des porösen Substrats liegt an einem Heizkörper an. Auf diese Weise stellt sich ein für das Verfahren maßgeblicher Temperaturgradient senkrecht zur Bauteiloberfläche ein. Die Oberflächentemperatur auf der kalten Seite wird über den Gasstrom so eingestellt, daß dort keine oder nur geringe Abscheidung stattfindet. Dadurch tritt keine Verengung der Poren in diesem Bereich auf. Der Nachteil dieses Verfahrens liegt in einem sehr hohen zur Kühlung erforderlichen Gasdurchsatz. Die geringe Ausbeute an abgeschiedenem Material führt zu langen Fertigungszeiten. Der apparative Aufwand für die Heizung ist hoch.

Bei einer weiteren bekannten Ausführungsform von CVI-Verfahren (DE 41 42 261 A1) durchströmt das Gas aufgrund erzwungener Konvektion zwangsweise das poröse Substrat, indem ein Druckgradient angelegt wird. Die Infiltrationszeit kann relativ kurz gehalten werden. Ab einem gewissen Porenfüllungsgrad wird jedoch ein Durchströmen der porösen Struktur immer aufwendiger.

Aus der US 4,580,524 ist ein CVI-Verfahren bekannt, bei dem Temperatur und Druckgradiententechniken miteinander kombiniert werden. Damit können relativ kurze Fertigungszeiten erzielt werden. Nachteil eines solchen Verfahrens ist der komplizierte Reaktoraufbau.

Mit der Erfindung wird die Aufgabe gelöst, ein CVI-Verfahren zu schaffen, mit dem bei vorgegebener Herstellungszeit höhere Porenfüllungsgrade bzw. bei vorgegebenem Porenfüllungsgrad kürzere Herstellungszeiten erzielbar sind.

Die Aufgabe wird erfindungsgemäß mit einem Verfahren mit den Merkmalen nach Anspruch 1 gelöst.

Das erfindungsgemäße Verfahren zu einer auf Diffusion in der porösen Struktur basierenden chemischen Gasphaseninfiltration von refraktären Stoffen, insbesondere von Kohlenstoff (C) und Siliciumcarbid (SiC), arbeitet isotherm, d.h. es werden keine Temperaturgradienten gezielt angelegt. Die Infiltration erfolgt isobar, d.h. die zu befiltrierende poröse Struktur wird in einer Reaktionszone mit einem Gas beströmt, nicht aber unter Ausbilden eines wesentlichen Druckgradienten durchströmt. Dabei werden für eine vorgegebene Temperatur in der Reaktionszone der Druck des Gases bzw. der Partialdruck eines in dem Gas enthaltenen Eduktgases und die Verweilzeit des Gases in der Reaktionszone derart eingestellt, daß in der porösen Struktur eine Abscheidungsreaktion im Druck- bzw. Partialdruckbereich der Sättigungsadsorption der die feste Phase bildendenden gasförmigen und flüchtigen Verbindungen vorliegt, wobei Sättigungsadsorption bedeutet, daß bei einer Erhöhung des Gasdruckes bzw. des Partialdruckes des Eduktgases die Abscheidungsgeschwindigkeit im wesentlichen konstant bleibt bzw. unwesentlich erhöht wird. D.h., daß die Abscheide- bzw. Infiltrationsgeschwindigkeit der festen Phase, mit anderen Worten der refraktären Stoffe, formal nach einer Reaktion nullter Ordnung, in jedem Fall jedoch nach einer Reaktion mit einer Ordnung wesentlich kleiner als eins verläuft. Ferner werden für die vorgegebene Temperatur in der Reaktionszone der Druck des Gases bzw. der Partialdruck eines in dem Gas enthaltenen Eduktgases und die Verweilzeit des Gases in der Reaktionszone derart eingestellt, daß die Umsetzung des Eduktgases in jedem Stadium der Infiltration so begrenzt wird, daß beim Durchströmen der Reaktionszone nicht mehr als 50 %, vorzugsweise 10 % bis 25 %, der im Eduktgas zugeführten, die feste Phase bildenden Elemente als feste Phase in der porösen Struktur abgeschieden werden. Außerdem erfolgt die Beströmung der porösen Struktur geradlinig von unten nach oben durch Spalten im wesentlichen gleicher Weite von 1 bis 50 mm, vorzugsweise weniger als 25 mm.

Dies bedeutet z.B., daß gegenüber den üblichen Verfahren wesentlich höheren Drücke und Partialdrücke der Eduktgase eingestellt werden, die höher sind als bei bekannten isobaren, isothermen Verfahren, um damit hohe bzw. höchste Abscheidegeschwindigkeiten zu ermöglichen. Die Drücke sind zumindest so hoch, daß sie im Lichte des Standes des Wissens und der Technik als nachteilig zu bezeichnen sind.

Deshalb sei nochmals betont, daß unter solchen Reaktionsbedingungen nicht nur maximale Infiltrationsgeschwindigkeiten, sondern auch maximale Porenfüllungsgrade erreicht werden.

Um bei hohen Drücken gleichzeitig eine gute Porenfüllung zu erreichen, erfordert das erfindungsgemäße Verfahren eine ganz spezielle Reaktionsführung. Dabei ist auch die Auswahl der Ausgangsverbindungen von besonderer Bedeutung. Das bedeutet, daß für die Abscheidung eines jeden refraktären Stoffes spezielle, dem erfindungsgemäßen Verfahren am ehesten entsprechende Ausgangsverbindungen ausgewählt werden.

Um das Wesen des erfindungsgemäßen Verfahrens zu erläutern, ist es notwendig, auf Chemie und Kinetik der Zersetzung der Ausgangsverbindungen unter simultaner Abscheidung der festen Phase einzugehen. Aus Gründen der Einfachheit soll dies am Beispiel der Abscheidung des Elementes Kohlenstoff erfolgen. Gl. (1) zeigt hierzu ein Schema mit Methan als Ausgangsstoff.

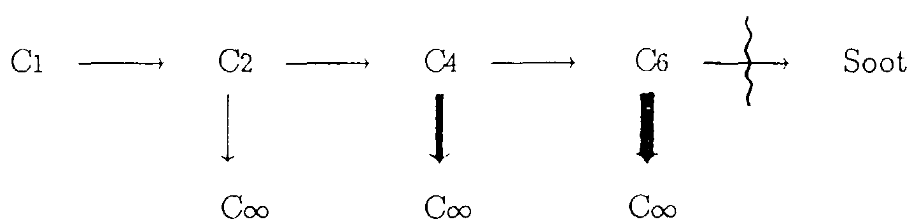 (1)

In diesem Schema bedeuten $C_1$ Methan, $C_2$ und $C_4$ stehen für $C_2$-und $C_4$- Kohlenwasserstoffe wie z.B. Ethylen, Acetylen und Butadien. $C_6$ bedeutet Benzol und ggfl. substituierte Benzole. Die obere Reaktionsfolge beschreibt die Gasphasenreaktionen bei der Pyrolyse von Methan, wie sie z.B. aus der Petrochemie (Crackreaktionen) bekannt sind. Die

Bildung höherer Aromaten wie Naphthalin, Anthracen, Pyren etc. in der Gasphase sollte möglichst vermieden werden, da sie zur Keimbildung in der Gasphase und damit zur unerwünschten Soot-Bildung führen. Die Pfeile in Gl. (1) nach unten sollen die Bildung von Kohlenstoff, m.a.W. dessen Abscheidung auf dem Substrat veranschaulichen. Der fehlende Pfeil bei Methan ($C_1$) bedeutet, daß dieses bzw. daraus entstehende $C_1$-Radikale nicht oder zumindest nur mit vernachlässigbarer Geschwindigkeit in der Lage sind, Kohlenstoff zu bilden. Die von $C_2$ zu $C_6$ zunehmende Dicke der Pfeile soll verdeutlichen, daß die Abscheidegeschwindigkeit von $C_2$ bis $C_6$ zunimmt, und zwar erheblich.

Das Schema zeigt also, daß Methan als Ausgangsverbindung von Kohlenstoff für eine chemische Gasphaseninfiltration ideal ist. Methan kann in die Poren diffundieren, aufgrund seiner kleinen Molmasse im Vergleich zu anderen Kohlenwasserstoffes mit maximaler Geschwindigkeit, Kohlenstoffabscheidung erfolgt jedoch erst, nachdem die $C_2$-, $C_4$- Kohlenwasserstoffe und Benzol gebildet werden.

Die Verwendung von Methan für die chemische Gasphaseninfiltration von Kohlenstoff ist nicht neu. Es ist im Gegenteil so, daß Methan bzw. Erdgas allein aufgrund seiner Preiswürdigkeit in Prozessen der chemischen Gasphaseninfiltration von Kohlenstoff bevorzugt Verwendung findet. Das Beispiel zeigt jedoch eindeutig die große Bedeutung der Ausgangsverbindung für die chemische Gasphaseninfiltration. Analoges läßt sich z.B. für die chemische Gasphaseninfiltration von Siliciumcarbid angeben. In diesem Fall werden in der Technik, d.h. bei industriellen Prozessen, als Ausgangsverbindungen nahezu ausschließlich Methylchlorsilane und insbesondere Methyltrichlorsilan, $CH_3SiCl_3$, verwendet. Speziell für diese Ausgangsverbindung wird angeführt, daß sie die Elemente der abzuscheidenden festen Phase, nämlich Silicium und Kohlenstoff, bereits in stöchiometrischer Zusammensetzung enthält. Tatsächlich erfolgt bei der Abscheidung von Siliciumcarbid aus Methyltrichlorsilan in der Regel Mitabscheidung von freiem Kohlenstoff. Um diese zu vermeiden, werden Gemische aus Methyltrichlorsilan und Wasserstoff verwendet. Betrachtet man die Zersetzungsreaktionen, so scheint Methyltrichlorsilan für eine Gasphaseninfiltration weniger geeignet (Gl. (2)):

$$CH_3SiCl_3 \rightarrow CH_3 + SiCl_3 \qquad (2)$$

Es entstehen nämlich unmittelbar Radikale, die Siliciumcarbid bilden können, in dem das Methyradikal mit einem Siliciumatom und das Silylradikal mit einem Kohlenstoffatom an der Oberfläche der wachsenden Siliciumcarbidschicht reagiert. Verwendet man dagegen die thermisch wesentlich stabileren verbindungen $SiCl_4$ und $CH_4$, so können diese primär in die Poren diffundieren, ehe Radikale gebildet werden, aus denen dann Siliciumcarbid entsteht. In Wirklichkeit ist die Gasphasenchemie komplexer. Zur Veranschaulichung des Prinzips ist jedoch die Betrachtung dieser Elementar- bzw. Primärreaktionen ausreichend.

Erfindungsgemäß werden die Konzentrationen bzw. die Partialdrücke der Ausgangsverbindungen des Prozesses in dem an die Poreneingänge angrenzenden Gasraum, der dem freien Reaktorvolumen entspricht, auf im wesentlichen ebenso hohe Werte eingestellt wie am Eintritt in den Reaktor. Die Zersetzung der Ausgangsverbindungen im freien Reaktorvolumen wird dadurch weitgehend vermieden, daß die Abscheidetemperatur und vor allem die Verweilzeit geeignet eingestellt werden. Es werden daher extrem kurze Verweilzeiten realisiert. Dadurch werden die infolge hoher Verweilzeit im freien Reaktorvolumen ablaufenden Zersetzungsreaktionen vermieden, die zu unerwünschter Abscheidung auf der Oberfläche oder an den Poreneingängen des porösen Substrates führen.

Die Zersetzungsreaktionen lassen sich besonders eindrucksvoll anhand von Gl. (1) für Methan dokumentieren. Bei langen Verweilzeiten im freien Reaktorvolumen können sich $C_2$-, $C_4$-Spezies und Benzol bilden, was zwangsläufig zur Kohlenstoffabscheidung auf der Oberfläche und an den Poreneingängen führt. Dieses Problem ist bei hohen Partialdrücken der Ausgangsverbindungen so kritisch, daß herkömmliche Verfahren mit hohen Partialdrücken zu extrem schlechten Ergebnissen führen.

Erfindungsgemäß wird ausgenutzt, daß kurze Verweilzeiten im freien Reaktorvolumen nicht kurze Verweilzeiten in den Poren bedeuten. Trotz der erfindungsgemäß eingestellten kurzen Verweilzeit im freien Reaktorvolumen können demzufolge in den Poren Zersetzungsreaktionen ablaufen und somit kann auch die feste Phase abgeschieden werden. Die Länge der Verweilzeit wird derart eingestellt, daß eine prozentual geringe Umsetzung des Eduktgases, d.h. eine geringe Abscheiderate der im Eduktgas zugeführten, die feste Phase bildenden Elemente als feste Phase in der porösen Struktur erreicht wird. Die zum Realisieren der gewünschten Abscheidungsrate konkret einzustellende Verweilzeit bei gegebenen Prozeßtemperaturen und -drücken ist dabei gegebenenfalls mit Hilfe von Testversuchen unter Bestimmen der verwendeten Eduktgaszusammensetzung und -menge sowie Auswiegen der Struktur vor bzw. nach der Gasphaseninfiltration zu ermitteln.

Die eingestellten kurzen Verweilzeiten sind notwendiges, aber nicht hinreichendes Merkmal des erfindungsgemäßen Verfahrens. Kurze Verweilzeiten bedingen hohe Strömungsgeschwindigkeiten, womit die Tendenz zur Bildung von Wirbeln verstärkt ist. Aufgrund der Zirkulationsströmungen in Wirbeln wird in diesen die Verweilzeit lokal erhöht, so daß es auch zu verstärkten Abscheidungen kommt, bei der chemischen Gasphaseninfiltration zwangsläufig an der Oberfläche der Substrate. Bei hohen Drücken bzw. Partialdrücken wie bei dem erfindungsgemäßen Verfahren

ist dies aufgrund der hohen Konzentrationen bzw. Partialdrücke der Ausgangsverbindungen besonders problematisch. Durch die Beströmung der porösen Struktur geradlinig von unten nach oben werden jedoch konvektiv versursachte Zirkulationsströmungen eingedämmt. Die Beströmung erfolgt erfindungsgemäß durch Spalten im wesentlichen gleicher Weite von 1 bis 50 mm, vorzugsweise weniger als 25 mm. Dabei handelt es sich um Spaltweiten, die gerade groß genug sind, daß kein schädliches wesentliches Druckgefälle angelegt werden muß, um die bei vorgegebener Verweilzeit erforderliche Strömungsgeschwindigkeit zu erreichen, jedoch gleichzeitig klein genug sind, daß die Ausbildung von Zirkulationsströmungen und die daraus resultierende lokale Erhöhung der Verweilzeit vermieden werden.

Die erfindungsgemäße Kombination von an sich kontraproduktiven Maßnahmen, nämlich dem Einstellen hoher Drücke einerseits und geringer Abscheidungsraten andererseits führt dazu, daß die chemische Gaspaseninfiltration nach dem erfindungsgemäßen Verfahren eine bisher bei weitem nicht erreichte Kombination einer hohen Fertigungsgeschwindigkeit und hoher Porenfüllungsgrade erreicht. Durch die Beströmung über geringe Spalte wird eine weitere Erhöhung der Porenfüllungsgrade erreicht, wobei ebenfalls die erforderliche Fertigungszeit weiter herabgesetzt wird, indem es vermieden wird, daß es zu Ablagerungen an der Bauteiloberfläche kommt, die ggf. abgeschliffen werden müssen.

Zur Durchführung des Verfahrens werden Reaktorkonstruktionen bzw. Reaktoreinbauten verwendet, die eine Umsetzung der speziellen Verfahrensbedingungen in technisch und wirtschaftlich optimaler Weise gestatten.

Die Reaktionstemperatur spielt eine ganz entscheidende Rolle für das erfindungsgemäße Verfahren. Sie beeinflußt sowohl die Reaktionsgeschwindigkeit, d.h. die Zersetzungs- und Abscheidungsreaktionen, als auch die Diffusion in die bzw. in den Poren, allerdings in sehr unterschiedlicher Weise. Für die Reaktionsgeschwindigkeit r gilt im einfachsten Fall unter Annahme einer Reaktion erster Ordnung Gl. (3),

$$|r| = k * c_i \qquad (3)$$

für die Diffusionsgeschwindigkeit j Gl. (4),

$$|j| = D * c_i \,. \qquad (4)$$

In diesen Gleichungen bedeuten:

k = Reaktionsgeschwindigkeitkonstante,

D = Diffusionskoeffizient,

$c_i$ = Konzentration einer Kompenente i.

Die Reaktionsgeschwindigkeitkonstante k und der Diffusionskoeffizient D werden wie folgt von der Temperatur beeinflußt (Gln. (5) und (6)):

$$k \sim \exp(-E_A/RT) \qquad (5)$$

$$D \sim T^{1.5} \qquad (6)$$

Dabei bedeuten:

$E_A$ = Aktivierungsenergie,

R = allgemeine Gaskonstante,

T = Temperatur in Kelvin.

Für die Kohlenstoffabscheidung liegen die Aktivierungsenergien zum Teil außerordentlich hoch. Im Falle von Methan beträgt die Aktivierungsenergie 105 kcal/mol. Eine geringe Änderung der Temperatur hat demzufolge eine sehr große Änderung der Reaktionsgeschwindigkeit zur Folge (Gln. (3) und (5)), während der Einfluß auf die Diffusion

relativ klein ist (Gln. (4) und (6)). Durch tiefe Temperaturen wird demzufolge die Diffusion im Vergleich zur Reaktion extrem begünstigt. Dies ist für die In-Poren-Abscheidung, also die Abscheidung innerhalb der Poren von Vorteil. Diese Schlußfolgerung ist Stand des Wissens. Gleichzeitig ist jedoch auch eine langsame Reaktionsgeschwindigkeit die Folge, die zu hohen Fertigungszeiten führt.

Erfindungsgemäß wird jedoch ein anderer, bislang unbeachteter Aspekt ausgenutzt. Die Gln. (3) und (4) zeigen, daß die Reaktionsgeschwindigkeit und die Diffusionsgeschwindigkeit von der Konzentration $c_i$ oder dem entsprechenden Partialdruck $p_i$ abhängen. Erhöht man diese, so werden Reaktionsgeschwindigkeit wie auch Diffusionsgeschwindigkeit gleichermaßen beschleunigt, wodurch für die Diffusionsgeschwindigkeit in bezug auf die Reaktionsgeschwindigkeit zumindest kein Nachteil entsteht. Der Einfluß einer verminderten Temperatur auf die Reaktionsgeschwindigkeit läßt sich somit durch eine signifikante Erhöhung der Konzentration $c_i$ bzw. des Partialdruckes $p_i$ kompensieren.

Bei der chemischen Gasphasenabscheidung und damit auch bei der chemischen Gasphaseninfiltration handelt es sich im entscheidenden Schritt nicht um eine homogene, sondern um eine heterogene Reaktion, so daß die Oberflächenreaktion bei der Abscheidung des Kohlenstoffs betrachtet werden muß. Ist diese eine Ein-Zentren-Reaktion, so ändert sich die Ordnung der Reaktionsgeschwindigkeit mit steigendem Partialdruck formal von eins nach null; man spricht im letzteren Fall von einer Sättigungsadsorption. Dies bedeutet für Gl. (3), daß die Reaktionsgeschwindigkeit unabhängig von der Konzentration $c_i$ bzw. Partialdruck $p_i$ wird (Gl. (7)):

$$|r| = k \qquad (7)$$

Erhöht man in diesem Fall Konzentration bzw. Partialdruck, so bleibt die Reaktionsgeschwindigkeit konstant, die Diffusionsgeschwindigkeit steigt jedoch an, was für eine In-Poren-Abscheidung von überragendem Vorteil ist. Tiefe Temperaturen und hohe Konzentrationen bzw. Partialdrücke sind deshalb simultan überragende Kriterien für das erfindungsgemäße Verfahren.

Erfindungsgemäß ist es möglich, daß das Gas mit dem die poröse Struktur beströmt wird, einen wesentlichen Anteil an Inert- bzw. Verdünnungsgasen aufweist, d.h. Stickstoff, Argon etc. Gemäß einer bevorzugten Ausführungsform wird dem Gas jedoch kein Inert- bzw. Verdünnungsgas beigemengt. Damit ist gemeint, daß durchaus ein Gas verwendet werden kann, das naturgemäß, wie gewisse Erdgase, einen geringen Anteil an Inertgasen bzw. Verdünnungsgasen enthält. Es soll jedoch nicht zusätzlich Inert-- bzw. Verdünnungsgas beigemischt werden, um z.B. den Partialdruck der Ausgangsverbindungen abzusenken.

Der Verzicht auf Inertgase gemäß dieser bevorzugten Ausführungsform der Erfindung wirkt auf mehrfache Weise vorteilhaft.

Im Vergleich zu Verfahren nach dem Stand der Technik werden hohe Konzentrationen bzw. Partialdrücke der Ausgangsverbindungen realisiert. Eine hohe Konzentration der Ausgangsverbindungen im freien Reaktorvolumen erhöht das Konzentrationsgefälle zu den Poren hin und damit die Triebkraft der Diffusion in die Poren. Möglichst hohe Konzentrationen bzw. möglichst hohe Partialdrücke der Ausgangsverbindungen sind auch aus einem anderen Grund von essentieller Bedeutung. Sind die Partialdrücke nämlich zu klein, so reagieren die Ausgangsverbindungen am Poreneingang ab, in der Tiefe der Poren erfolgt jedoch keine Abscheidung mehr. Es würde im Endergebnis zum Porenverschluß kommen, ohne daß die Pore gefüllt ist.

Ferner können Inertgas-Moleküle mit den Ausgangsverbindungen in der Gasphase Stöße machen, wodurch die Zersetzung der Ausgangsverbindungen beschleunigt wird. Inertgase sind demzufolge nicht absolut inert. Bei der Kohlenstoffabscheidung bzw. Kohlenstoffinfiltration mit Methan als Ausgangsstoff z.B. wird durch den Verzicht auf Inertgase daher die Kohlenstoffabscheidung auf der äußeren Oberfläche bzw. an den Poreneingängen des porösen Substrates verringert, so daß höhere Porenfüllungsgrade ermöglicht werden.

Der Ausschluß des Beimengens von Inert- oder Verdünnungsgasen bei der bevorzugten Ausführungsform des erfindungsgemäßen Verfahrens erfolgt unter diesen Gesichtpunkten trotz der Tatsache, daß dieser Ausschluß eine Erhöhung des Partialdruckes und damit eine vermeintlich die Porenfüllung verschlechternde Wirkung hat.

Erhöht man unter der Voraussetzung, daß Inert- bzw. Verdünnungsgase nicht verwendet werden, den Partialdruck, so ist dies gleichbedeutend mit einer Erhöhung des Gesamtdruckes, der wiederum den Diffusionskoeffizienten D und damit die Diffusionsgeschwindigkeit j negativ beeinflußt; es gilt (Gl. (8)):

$$D \sim p^{-1} \qquad (8)$$

p = Gesamtdruck

Dieser Einfluß des Gesamtdruckes auf die Reaktionsgeschwindigkeit stellt aus zwei Gründen kein Problem

für das erfindungsgemäße Verfahren dar:

(1) Bei Abscheidungen mit reinem Gas ohne Inertgas wird die Sättigungsadsorption bei einem kleineren Druck erreicht, da der Partialdruck identisch dem Gesamtdruck ist.

(2) Im Falle von Sättigungsadsorption wird das Verhältnis von Reaktionsgeschwindigkeit und Diffusionsgeschwindigkeit durch steigenden Druck der Ausgangsgase ebenfalls nicht beeinflußt, da sowohl die Reaktionsgeschwindigkeit nach Gl. (7) als auch die Diffusionsgeschwindigkeit nach Gl. (9) unabhängig vom Gesamtdruck sind:

$$| j | = D_{(p)} * c \sim 1/p * p \sim 1 \qquad (9)$$

$D_{(p)}$ entspricht Gl. (8) .

Durch die Ausnutzung dieser Effekte wird es erfindungsgemäß erreicht, mit hohen Drücken der Ausgangsgase optimale Bedingungen für eine In-Poren-Abscheidung zu erzielen. Bei Mehr-Zentren-Reaktionen ist die Kinetik der Oberflächenreaktion wesentlich komplexer. Es gilt jedoch auch in diesem Fall, daß die maximale Reaktionsgeschwindigkeit bei Sättigungsadsorption aller Spezies, die in jedem Fall angestrebt werden muß, bei konstantem Partialdruckverhältnis der Ausgangsstoffe zu keinem weiteren Anstieg der Reaktionsgeschwindigkeit der Oberflächenreaktion führt. Damit haben dieselben Überlegungen wie bei der Ein-Zentren-Reaktion Gültigkeit.

Entscheidend für das erfindungsgemäße Verfahren sind somit die richtige Wahl der Ausgangsverbindungen, hohe Drücke und insbesondere hohe Partialdrücke der Ausgangsverbindungen und tiefe Temperaturen, die in Verbindung mit einer kurzen Verweilzeit nur eine geringe Zersetzung der Ausgangsverbindungen im freien Reaktionsraum zulassen.

Erfindungsgemäß können für die Gasphaseninfiltration mit den jeweiligen Ausgangsverbindungen geeignete niedrige Temperaturen realisiert werden.

Gemäß einer bevorzugten Ausführungsform werden für die Gasphaseninfiltration von C in der Reaktionszone Temperaturen im Bereich von 1000 bis 1200°C eingestellt.

Gemäß einer weiteren bevorzugten Ausführungsform werden für die Gasphaseninfiltration von SiC in der Reaktionszone Temperaturen im Bereich von 900 bis 1100°C eingestellt.

Gemäß einer bevorzugten Ausführungsform der Erfindung wird die poröse Struktur mit einem Gas beströmt, das ein bei der Gasphaseninfiltration entstehendes Nebenprodukt aufweist. Vorzugsweise wird für die Gasphaseninfiltration von C dem Eduktgas Wasserstoff beigemischt. Bevorzugt beträgt das Volumenverhältnis von Methan bzw. Erdgas und beigemischtem Wasserstoff dabei 20 : 1 bis 2 : 1, vorzugsweise 10 : 1 bis 5 : 1. Für die Gasphaseninfiltration von SiC wird dem Eduktgas bevorzugt Chlorwasserstoff beigemischt. Dabei beträgt das molare Verhältnis von Methyltrichlorsilan und beigemischtem Chlorwasserstoff vorzugsweise 5 : 1 bis 1 : 5, weiter vorzugsweise 3 : 1 bis 1 : 2.

Durch das Beimischen von Wasserstoff zum Eduktgas Methan werden zwei weitere vorteilhafte Effekte erzielt:

(1) Der Diffusionskoeffizient für das Methan wird entscheidend erhöht, d.h. die Porendiffusion wird entscheidend begünstigt.

(2) Durch den Wasserstoffanteil verringert sich die Volumenzunahme infolge der Totalzersetzung von Methan zu Kohlenstoff und Wasserstoff in den Poren der porösen Struktur; demzufolge wird der Ausspüleffekt abgeschwächt.

Durch eine Beigabe von Wasserstoff wird erreicht, daß bereits bei geringeren Methanpartialdrücken Bedingungen der Sättigungsadsorption einstellbar sind. Erfindungsgemäß ist es jedoch auch möglich, die Sättigungsadsorption bereits bei kleineren Methanpartialdrücken unabhängig von einer Veränderung des Wasserstoffanteils durch Einstellen tieferer Temperaturen zu erreichen. Diese Maßnahme greift also auch dann, wenn dem Methan kein Wasserstoff beigemischt wird. Es genügt eine relativ kleine Temperaturerniedrigungen in der Größenordnung von 20 °C, beispielsweise von 1100 °C auf 1080 °C, um den Methanpartialdruck, bei dem Sättigungsadsorption erreicht wird, deutlich herabzusetzen. Durch solche geringen Temperaturabsenkungen wird die Diffusion in den Poren der porösen Struktur praktisch nicht beeinträchtigt, da die Diffusionskoeffizienten nur sehr geringe Temperaturabhängigkeiten zeigen. Der Effekt einer Temperaturabsenkung um 20 °C auf die Erniedrigung des Methanpartialdruckes, bei dem Sättigungsadsorption erreicht wird, ist etwa vergleichbar mit dem Effekt einer Wasserstoffbeimengung im Verhältnis Methan/Wasserstoff von 6 : 1.

Erfindungsgemäß besteht somit die Möglichkeit, die Sättigungsadsorption als ein entscheidendes Kriterium des Verfahrens mittels zweier verschiedener, voneinander weitgehend unabhängiger Parameter in einem relativ weiten

Bereich von Drücken bzw. Partialdrücken einzustellen. Dadurch gelingt es, für jede poröse Struktur, unabhängig von deren Porösität, Porenradienverteilung oder Porenstruktur und vor allem unabhängig von deren geometrischen Abmessungen, die erfindungsgemäßen Infiltrationsbedingungen, insbesondere im Bezug auf die Sättigungsadsorption, einzustellen. Von besonderem Vorteil ist es dabei, daß bei Veränderung der entscheidenden Parameter Temperatur und Wasserstoffpartialdruck für das Verfahren insgesamt keine unerwünschten Nachteile entstehen. Im Sinne einer möglichst schnellen Infiltration werden in jedem Falle möglichst hohe Drücke bzw. Partialdrücke bevorzugt, insbesondere Drücke von 15 bis 25 kPa.

Analoge Steuerungsmöglichkeiten der Sättigungsadsorption existieren auch im Falle der chemischen Gasphaseninfiltration von Siliciumcarbid. Eine Temperaturerniedrigung führt stets zu einer Sättigungsadsorption bei kleineren Partialdrücken. Somit besteht durch Temperaturerhöhung generell die Möglichkeit, den Druck bzw. Partialdruck auf einen optimalen Wert einzustellen, beispielsweise auch zu erhöhen. Bei Vorliegen von Sättigungsadsorption bedeutet dies, daß die Abscheidungsgeschwindigkeit nicht weiter ansteigt, wohl aber der Diffusionstrom in den Poren, da durch den höheren Partialdruck die Triebkraft für die Diffusion größer ist. Die Rolle des Wasserstoffs in bezug auf die Sättigungsadsorption bei der Infiltration von Kohlenstoff übernimmt bei der Infiltration von Siliciumcarbid Chlorwasserstoff. Durch Chlorwasserstoff läßt sich die Sättigungsadsorption ebenfalls bei kleineren Drücken bzw. Partialdrücken erreichen; der Nebeneffekt auf die Diffusion ist allerdings nicht so herausragend wie im Falle des Wasserstoffs. Das Problem der Volumenvermehrung bei der Totalzersetzung von Methyltrichlorsilan zu Siliciumcarbid und Chlorwasserstoff in den Poren der porösen Struktur ist a priori noch größer als bei der Totalzersetzung von Methan; es wird jedoch bereits dadurch drastisch vermindert, daß für die Abscheidung bzw. Infiltration von Siliciumcarbid Gemische aus Methyltrichlorsilan und Wasserstoff mit Wasserstoffanteilen verwendet werden, die den Anteil von Methyltrichlorsilan um ein mehrfaches übertreffen.

Bevorzugt wird das erfindungsgemäße Verfahren in einem Reaktor einer speziellen Reaktorkonstruktion bzw. zumindest einem Reaktor mit speziellen Einbauten durchgeführt, die ebenfalls Gegenstand der Erfindung sind. Da Bremsscheiben aus kohlenstoffaserverstärktem Kohlenstoff zu den mengenmäßig wichtigsten Produkten zählen, die durch chemische Gasphaseninfiltration, und zwar von Kohlenstoff in Kohlenstoffaserstrukturen hergestellt werden, und außerdem ein erkennbares Wachstumspotential besitzen, wird das Prinzip der Reaktorkonstruktion bzw. der Reaktoreinbauten an diesem Beispiel erläutert. In Figur 1 sind schematisch ein Reaktorquerschnitt zur Verdeutlichung der Reaktoreinbauten und eine Aufsicht auf ein Einbauteil wiedergegeben.

Der Übersicht halber sind im vertikalen Querschnitt die Trage- bzw. Halterungskonstruktionen weggelassen. Die Einbauteile können aus einer Keramik bestehen; vorzugsweise wird jedoch Kohlenstoff bzw. Graphit verwendet. Die Dicke der Einbauteile und die Aussparungen entsprechen dem Durchmesser der Bremsscheiben. Die Ausgangsverbindung durchströmt die in ihrer Breite nicht maßstäblich wiedergegebenen Zwischenräume zwischen den Einbauten. Bei entsprechend kleinem Abstand der Einbauteile voneinander kann auf diese Weise eine sehr hohe Geschwindigkeit bei relativ kleinem Volumenstrom und geringer Tendenz zur Bildung von Wirbeln erreicht werden. Dies ist besonders wichtig, da nur ein geringer Umsatz der Ausgangsverbindungen infolge Zersetzung zugelassen werden kann.

Die Reaktorkonstruktion gemäß Figur 1 findet stets dann Anwendung, wenn relativ flache Teile, oder wie im vorliegenden Beispiel Teile mit großen Durchmesser (Längen)-zu-Dicken-Verhältnis infiltiert werden müssen. Besteht die Aufgabe in der Infiltration von Teilen mit mittlerem oder kleinem Durchmesser (Längen)-zu-Dicken-Verhältnis, so ist ein Reaktoraufbau gemäß Figur 2 verfahrensgemäß. Es zeigt einen horizontalen Querschnitt des Reaktors. In diesem Fall besteht der Reaktoraufbau aus einem Vollmaterial, vorzugsweise aus Kohlenstoff bzw. Graphit, mit senkrechten Röhren, in die die zu infiltrierenden Teile eingesetzt werden. Derselbe Aufbau läßt sich auch anwenden, wenn bei flachen Teilen die radiale Infiltration gegenüber der axialen Infiltration begünstigt ist, beispielsweise bei Lagen aus Fasergewebe.

Am Beispiel dieser Reaktorkonstruktionen läßt sich das Prinzip der Infiltration bei kleinen bzw. kleinsten Partialdrücken, wie in der Technik angewandt, in leicht verständlicher Weise erläutern. Infolge des sehr geringen Druckes ist die Diffusionsgeschwindigkeit hoch, so daß die Diffusion in die Poren begünstigt ist. Dies schließt nicht aus, daß die Ausgangsverbindungen bereits am Poreneingang abreagieren, nämlich infolge Adsorption an aktiven Zentren. Es erfolgt zu Beginn der Infiltration Abscheidung nur im unteren Bereichs des Reaktors, da die Ausgangsverbindungen völlig umgesetzt, d.h. verbraucht werden. Mit fortschreitender Infiltration und Füllung der Poren und damit Verkleinerung der inneren Oberfläche nimmt der Verbrauch der Ausgangsverbindungen in diesem Bereich ab, so daß sich die Infiltration in den mittleren Bereich verlagert. Insgesamt bedeutet das, daß die Reaktionsfront von unten nach oben durch den Reaktor hindurchwandert. Neben der kleinen Infiltrationsgeschwindigkeit an sich erhöht sich hierdurch die Infiltrationszeit zusätzlich.

Im Prinzip kann das erfindungsgemäße Verfahren mit den beschriebenen Reaktoren durchgeführt werden. Wegen der geringen Umsätze der Ausgangsverbindungen kann jedoch eine Kreislaufführung wirtschaftlich vorteilhaft sein. Zu deren Realisierung ist eine Betrachtung des den Reaktor verlassenen Gases und vor allem dessen Zusammensetzung notwendig. Als Beispiel wird die Kohlenstoffabscheidung aus Methan betrachtet. Gemäß Gl. (1) können als Reaktionsprodukte $C_2$ - bis $C_4$ - Kohlenwasserstoffe und Benzol, ggfl. in Spuren höhere Aromaten entstehen. Diese

würden wegen ihrer hohen Neigung zur Bildung von Kohlenstoff auch nach Anreicherung des Gases mit frischem Methan extrem stören. Ihre weitgehende Entfernung ist deshalb notwendig. Die am stärksten störenden Verbindungen, Benzol und höhere Aromaten, können im Prinzip durch Auskondensieren entfernt werden. Eine zu bevorzugende Variante, bei der auch die $C_2$ - bis $C_4$ - Kohlenwasserstoffe mit entfernt werden, nutzt deren im Vergleich zu Methan wesentlich höhere Zersetzungsgeschwindigkeit unter Bildung von Kohlenstoff, wie in G1. (1) angegeben. Voraussetzung zur Entfernung des gebildeten Kohlenstoffs aus dem Gasstrom ist eine große Oberfläche zu dessen Abscheidung. Solche Bedingungen lassen sich in einer Wirbelschicht mit feinem Wirbelgut erzeugen. Dieses kann ein Kohlenstoff- oder ein Keramik-Pulver sein. Bei Betrieb der Wirbelschicht wird ein gewisser Anteil an frischen Teilchen kontinuierlich zugeführt, ein entsprechender Anteil mit Hilfe eines Überlaufes in der Wirbelschicht abgeführt. Hierdurch ist ein stationärer Betrieb möglich. Werden Keramik-Pulver wie Aluminiumoxid-Pulver verwendet, so können die mit Kohlenstoff beschichteten Teilchen durch Verbrennen des Kohlenstoffs zur Energieerzeugung genutzt und anschließend wieder in die Wirbelschicht gefördert werden.

Zur selektiven Entfernung der unerwünschten Kohlenwasserstoffe bei gleichzeitig minimierter Methanzersetzung muß die Wirbelschicht unterhalb der Temperatur des Abscheidungs- bzw. Infiltrationsreaktors betrieben werden. Im Falle der Kohlenstoffinfiltration mit Methan ist eine typische Temperatur 1050 bis 1100°C. Die Wirbelschicht wird bei etwa 100 K tieferer Temperatur betrieben. Diese Vorgehensweise zur Abtrennung der unerwünschten Kohlenwasserstoffe ist aus zwei Gründen möglich. Der erste Grund wird durch Gl. (1) beschrieben. Der zweite, noch wichtigere Grund ist die wesentlich höhere Aktivierungsenergie der Methanzersetzung im Vergleich zur Kohlenstoffbildung aus den $C_2$ - bis $C_4$ -Kohlenwasserstoffen, Benzol und höheren Aromaten. Eine geringe Temperaturabsenkung ermöglicht demzufolge eine Abreaktion der unerwünschten Kohlenwasserstoffe, die durch die große Oberfläche in der Wirbelschicht noch unterstützt wird, weil die hohe Reaktionsgeschwindigkeit mit abnehmender Temperatur nur geringfügig erniedrigt wird. Im Fall von Methan wird die Zersetzungsreaktion durch diese Temperaturabsenkung dagegen nahezu eingefroren, d.h. sie läuft nicht oder nur in vernachlässigbarem Umfang ab.

Bei den bisherigen Betrachtungen wurde nicht berücksichtigt, daß sowohl bei der Zersetzung von Methan im Abscheidungs- bzw. Infiltrationsreaktor als auch bei der Kohlenstoffabscheidung in der Wirbelschicht Wasserstoff entsteht. Würde dieser nicht entfernt werden, ergäbe sich eine kontinuierliche Wasserstoffanreicherung im Kreislaufgas. Es ist deshalb erforderlich, nach dem Wirbelschichtreaktor und vor der Einspeisung von frischem Methan eine gewisse Menge an Gas auszuschleusen, damit der Wasserstoffpartialdruck im Kreislaufgas konstant bleibt. Die Menge des auszuschleusenden Gases richtet sich in erster Linie nach der Zersetzung des Methans im Abscheidungs- bzw. Infiltrationsreaktor. Das ausgeschleuste Gas kann als hochkaloriges Brenngas verwendet werden, unter Umständen auch zur Beheizung des Abscheidungsreaktors.

Dennoch verbleibt ein gewisser Anteil an Wasserstoff im Kreislaufgas. Wasserstoff ist nicht als Inertgas zu bezeichnen, da es sowohl in die Zersetzungsreaktionen des Methans in der Gasphase als auch in die Abscheidungsreaktionen des Kohlenstoffs auf der Substratoberfläche eingreift. Bei der chemischen Gasphaseninfiltration ist ein gewisser Wasserstoffpartialdruck sogar von Vorteil. Er vermindert die Zersetzung von Methan in der Gasphase und erhöht aufgrund seiner kleinen Molmasse die Diffusion in die Poren. Es wird anhand von Beispielen gezeigt, daß mit Wasserstoff im Kreislaufgas eine noch bessere Porenfüllung gelingt als ohne Wasserstoff.

Die voranstehenden Betrachtungen konzentrierten sich auf die chemische Gasphaseninfiltration von Kohlenstoff. Sie sind analog für die chemische Gasphaseninfiltration anderer refraktärer Stoffe gültig, insbesondere für die chemische Gasphaseninfiltration von Siliciumcarbid. Auch in diesem Fall können höhere und zum Teil zyklische, dem Benzol ähnliche Verbindungen gebildet werden, die aus dem Kreislaufgas entfernt werden müssen und in analoger Weise in einem Wirbelschichtreaktor entfernt werden können. Als Reaktionsgas entsteht bei der Abscheidung von Siliciumcarbid nicht Wasserstoff, sondern Chlorwasserstoff. Dieser muß in analoger Weise wie Wasserstoff bei der Kohlenstoffabscheidung teilweise aus dem Prozeß- bzw. Kreislaufgas entfernt werden.

Durch die Bildung von Chlorwasserstoff und dessen Kreislaufführung ist es abweichend von Gl. (2) auch möglich, Methyltrichlorsilan als Eduktgas zu verwenden, da dieses mit Chlorwasserstoff mit hoher Selektivität zu SiCl4 und CH4 abreagiert (Gl. (10)):

$$CH_3SiCl_3 + HCl \rightarrow SiCl_4 + CH_4 \qquad (10)$$

Der Vorteil von Methyltrichlorsilan liegt in der leichteren Handhabbarkeit.

Erfindungsgemäß ist es möglich, daß das Infiltrieren der porösen Struktur unter Vornehmen einer mechanischen Reinigung der Oberfläche der porösen Struktur unterbrochen wird. Gemäß einer bevorzugten Ausführungsform der Erfindung wird das Infiltrationsverfahren jedoch ohne eine Unterbrechung unter Vornehmen einer mechanischen Reinigung der Oberfläche der porösen Struktur durchgeführt.

Ein Schema einer kompletten, erfindungsgemäßen Anlage für die chemische Gasphaseninfiltration ist im

Figur 3 wiedergegeben.

Anhand von experimentellen Untersuchungen konnten die Vorzüge des erfindungsgemäßen Verfahrens bestätigt werden. Beispiele von experimentellen Untersuchungen der Infiltration von Kohlenstoff, die solche Effekte bestätigt haben, die das erfindungsgemäße Verfahren ausnutzt, werden im folgenden unter Bezugnahme auf die Zeichnung dargestellt.

In der Zeichnung zeigt:

Figur 1 eine Schemaskizze eines Infiltrationsreaktors für Teile mit großem Durchmesser- bzw. Längen-zu-Dicken-Verhältnis;

Figur 2 einen horizontalen Schnitt durch das Einbauteil eines Infiltrationsreaktors für zylindrische Teile mit mittlerem bis kleinem Durchmesser/Längen-zu-Dicken-Verhältnis;

Figur 3 ein schematisches Verfahrensflußdiagramm bei Kreislaufführung mit Abscheidung von Zwischenprodukten;

Figur 4 einen Schnitt durch den Versuchsreaktor, schematisch dargestellt;

Figur 5 das kumulierte Porenvolumen des porösen, zylindrischen Substrates in Abhängigkeit vom Porendurchmesser;

Figur 6 die relative Massenzunahme des porösen, zylindrischen Substrates in Abhängigkeit von der Infiltrationszeit bei den folgenden Bedingungen: $p_{total}$ = 20 kPa, T = 1100 C°, $\tau$ = 0,16 Sek., Methan/Argon-Gemische unterschiedlicher Zusammensetzung;

Figur 7 die Anfangsgeschwindigkeit der relativen Massenzunahme in Abhängigkeit des Methanpartialdruckes bei den Verfahrensbedingungen entsprechend Figur 6;

Figur 8 eine Darstellung der Ergebnisse gemäß Figur 7 nach Gleichung 12;

Figur 9 den Porenfüllungsgrad in Abhängigkeit vom Methanpartialdruck bei den Verfahrensbedingungen entsprechend Figur 6, wobei die Porenfüllungsgrade nach den Gleichungen (13) und (14) berechnet sind;

Figur 10 den Porenfüllungsgrad in Abhängigkeit von der Infiltrationsgeschwindigkeit, dargestellt mit Hilfe der Anfangsgeschwindigkeit der Infiltration;

Figur 11a das kumulierte Porenvolumen eines porösen, zylindrischen Substrates nach 76 Stunden Infiltration bei den Infiltrationsbedingungen: $p_{total}$ = 20 kPa, T = 1100 C°, $\tau$ = 0,16 s, $p_{CH4}$ = 2,5 kPa, $p_{Ar}$ = 17,5 kPa;

Figur 11b das kumulierte Porenvolumen eines porösen, zylindrischen Substrates nach 79 Stunden Infiltration bei den Infiltrationsbedingungen $p_{total}$ = 20 kPa, T = 1100 C°, $\tau$ = 0,16 s, $p_{CH4}$ = 10 kPa, $p_{Ar}$ = 10 kPa;

Figur 12 die relative Massenzunahme eines porösen, zylindrischen Substrates in Abhängigkeit von der Infiltrationszeit bei den Infiltrationsbedingungen T = 1100 C°, $p_{total}$ = $p_{CH4}$, $\tau$ = 0,16 s;

Figur 13 die relative Massenzunahme eines porösen, zylindrischen Substrates in Abhängigkeit von der Infiltrationszeit bei den Infiltrationsbedingungen T = 1100 C°, $p_{total}$ = 20 kPa, $p_{H2}$ = 2,5 kPa, $p_{CH4}$ steigend, $p_{Ar}$ fallend;

Figur 14 die Anfangsgeschwindigkeit der relativen Massenzunahme in Abhängigkeit des Methanpartialdruckes bei den Infiltrationsbedingungen entsprechend Figur 13;

Figur 15 den Porenfüllungsgrad in Abhängigkeit vom Methanpartialdruck bei den Infiltrationsbedingungen entsprechend Figur 13;

Figur 16 den Porenfüllungsgrad in Abhängigkeit von der Anfangsgeschwindigkeit der Infiltration bei den Infiltrationsbedingungen entsprechend Figur 13;

Figur 17 das kumulierte Porenvolumen eines porösen, zylindrischen Substrates nach 77 Stunden Infiltration bei

den Infiltrationsbedingungen $p_{total}$ = 20 kPa, T = 1100 C°, $\tau$ = 0,16 Sek., $p_{CH4}$ = 15 kPa, $p_{Ar}$ = 2,5 kPa, $p_{H2}$ = 2,5 kPa;

Figur 18 die relative Massenzunahme eines porösen, zylindrischen Substrates in Abhängigkeit von der Infiltrationszeit bei den Infiltrationsbedingungen $p_{total}$ = 50 kPa, T = 1100 C°, $p_{CH4}$ = 43,75 kPa, $p_{H2}$ = 6,25 kPa;

Figur 19 die Anfangsgeschwindigkeiten der relativen Massenzunahme in Abhängigkeit vom Methanpartialdruck, der im Fall des reinen Methans, d.h. der oberen dargestellten Kurve, dem Gesamtdruck entspricht.

Untersuchungsbeispiel 1:

Die Untersuchungen zu dem erfindungsgemäßen Verfahren wurden in einem vertikalen kurzen Rohrreaktor mit konischer Anströmdüse durchgeführt. Dieser approximiert einen technischen Abscheidungsreaktor gemäß Figur 2. Figur 4 zeigt eine Schemazeichnung des Reaktors. Das zylindrische, poröse Substrat aus Aluminiumoxid-Keramik hat einen Durchmesser von 16 mm. Der Spalt zwischen diesem Substrat und der Reaktorwand weist eine Weite von 2 mm auf. Das poröse Substrat lagert auf einem auf dem Kopf stehenden Kegel aus massiver Keramik; es ist oben mit einer Platte aus massiver Keramik abgedeckt, um eine Infiltration bevorzugt in radialer Richtung zu gewährleisten. Durch die konischen Anströmdüsen wird erreicht, daß die Ausgangsgase praktisch unzersetzt in den zylindrischen Abscheideteil des Reaktors gelangen. Durch die vertikale Anordnung, den Kegel und die konzentrische Anordnung des Zylinders mit dünnen Spalten zwischen Wand, Kegel sowie zylindrischer Probe ist eine definierte wirbelarme Strömung des Gases mit kurzer Verweilzeit bei mäßigen Gasflüssen möglich, es können also die Bedingungen des erfindungsgemäßen Verfahrens realisiert werden.

Das bei allen Verfahren benutzte poröse zylindrische Substrat hat einen Durchmesser von 1,6 cm, eine Höhe von 2 cm und eine Körperdichte von 2,86 g/cm; es besteht aus einer Aluminium-Keramik. Die offene Porosität beträgt 23,24 %; geschlossene Porosität ist nicht vorhanden. Figur 5 zeigt die Porendurchmesserverteilung, bestimmt mit Hilfe der Quecksilberporosimetrie. Diese Porendurchmesserverteilung dient in den folgenden Untersuchungsbeispielen als Referenz für infiltrierte Proben. Die Infiltration in diesen und in allen folgenden Beispielen erfolgte stets bei 1100°C und einer mittleren Verweilzeit von 0,16 s, bezogen auf den zylindrischen Reaktorteil.

Das erste Untersuchungsbeispiel behandelt den Einfluß des Methanpartialdrucks bei einem Gesamtdruck von 20 kPa. Der Methanpartialdruck wurde durch Zumischen von Argon als Inertgas variiert. Somit läßt sich simultan auch der Einfluß des Inertgases darstellen.

In Figur 6 ist die relative Massezunahme der Probe infolge des infiltrierten Kohlenstoffs in Abhängigkeit von der Infiltrationsdauer wiedergegeben. Eine relative Massezunahme von 0,15 entspricht einer Porenfüllung von 94 % (siehe später). Figur 6 zeigt nun, daß die Geschwindigkeit der Infiltration mit steigendem Methanpartialdruck zunimmt, und zwar im gesamten Bereich der untersuchten Partialdruck von 2,5 bis 20 kPa, wobei letzterer Partialdruck dem Gesamtdruck entspricht. Besonders eindeutig ist dieses an der Anfangssteigung der Kurven, $[d(\Delta m/m_0)/dt]_{t=0}$ , zu erkennen.

Figur 7 zeigt diese Geschwindigkeiten in Abhängigkeit vom Methanpartialdruck. Es ergibt sich ein eindeutig hyperbolischer Kurvenverlauf, d.h. die Reaktionsgeschwindigkeit in Abhängigkeit vom Methanpartialdruck folgt nur bei sehr kleinem Partialdruck formal einem Gesetz 1. Ordnung, bei hohem Partialdruck geht die Ordnung gegen Null. In diesem Falle ist Sättigungsadsorption erreicht, d.h. bei weiterer Steigung des Methanpartialdrucks nimmt die Abscheidegeschwindigkeit nicht weiter zu.

Die hyperbolische Kurve in Figur 7 läßt sich vereinfacht durch folgende Gl. (11) beschreiben:

$$\left[\frac{d(\Delta m/m_o)}{dt}\right]_{t=0} = \frac{k_1 * p_{CH4}}{k_2 + k_3 * p_{CH4}} \qquad (11)$$

Man sieht, daß bei kleinen Methanpartialdrücken die Geschwindigkeit der Reaktion formal nach erster Ordnung, bei hohem Methanpartialdruck formal nach nullter Ordnung verläuft, nämlich dann, wenn Sättigungsadsorption vorliegt. Der Kehrwert von G1. (11) ergibt Gl. (12):

$$\left[\frac{d(\Delta m/m_o)}{dt}\right]^{-1}_{t=0} = \frac{k_3}{k_1} + \frac{k_2}{k_1} * p_{CH4}^{-1} \quad (12)$$

Trägt man die Messpunkte von Figur 7 gemäß Gl. (12) auf, so ergibt sich eine eindeutige Gerade (Figur 8). Sie bestätigt den hyperbolischen Verlauf und damit die mehrfach beschriebene Sättigungsadsorption.

Figur 6 zeigt bei höheren Infiltrationszeiten aber auch, daß bei kleineren Methanpartialdrücken auch nach unendlich langer Infiltrationszeit offensichtlich nicht dieselbe relative maximale Massenzunahme erreicht wird wie bei hohen Methanpartialdrücken. Aus dem bei hohen Methanpartialdrücken erkennbaren Grenzwert folgt, daß die Abscheidung auf der äußeren Substratoberfläche in bezug auf die relative Massenzunahme zu vernachlässigen ist.

Die Kurven in Figur 6 durch die Meßpunkte wurden durch die Anpassung mit Hilfe der empirischen Funktion Gl. (13) gezeichnet.

$$\Delta m/m_o = (\Delta m/m_o)_{t=\infty} * (1-\exp(-k * t)) \quad (13)$$

$(\Delta m/m_0)_{t=\infty}$ = maximale relative Massenzunahme bei der jeweiligen Infiltration.

Aufgrund der Gesamtporosität von 23,24 % und einer Dichte des infiltrierten Kohlenstoffs von 2,07 g/cm ergibt sich bei vollständiger Infiltration der Poren eine maximal mögliche relative Massenzunahme von $[(\Delta m/m_0)_{t=\infty}]_{max}$ von 0,1594. Das Verhältnis aus der maximalen relativen Massenzunahme $(\Delta m/m_0)_{t=\infty}$ und $[(\Delta m/m_0)_{t=\infty}]_{max}$ ergibt den Porenfüllungsgrad, Gl. (14) :

$$\frac{(\Delta m/m_o)_{t=\infty}}{\left[(\Delta m/m_o)_{t=\infty}\right]_{max}} = PFG \quad (14)$$

Figur 9 zeigt die Porenfüllungsgrade aufgrund der Infiltration der Poren in Abhängigkeit vom Partialdruck des Methans. Es ist völlig eindeutig, daß der Porenfüllungsgrad mit dem Methanpartialdruck ansteigt. Es wird somit bestätigt, daß unter den Bedingungen des erfindungsgemäßen Verfahrens hohe Methanpartialdrücke nicht nur die Infiltration beschleunigen, sondern auch zu einem zunehmend höheren maximalen Porenfüllungsgrad führen.

Um das Bild abzurunden, kann man die Porenfüllungsgrade auch in Abhängigkeit von der Infiltrationsgeschwindigkeit darstellen; diese Darstellung ist in Figur 10 gezeigt. Diese Figur demonstriert nun direkt und eindeutig, daß die bei dem erfindungsgemäßen Verfahren realisierten hohen Infiltrationsgeschwindigkeiten eine maximale Porenfüllung ermöglichen und nicht etwa kleine Infiltrationsgeschwindigkeiten, wie in der Literatur, z.B. W.V. Kotlensky, in Chemistry and Physics of Carbon, Vol. 9, edited by P.L. Walker, P.A. Thrower, Marcel Dekker, New York, 1973, S. 187 postuliert: "Theoretically, the most ideal condition for pyrolytic carbon deposition in the pores will be given at infinitely small deposition rate". Die Ergebnisse dokumentieren außerdem sehr eindrucksvoll, daß die Verwendung eines Inert- oder Verdünnungsgases für eine maximale Porenfüllung ebenso schädlich ist wie eine kleine Infiltrationsgeschwindigkeit.

Die Figuren 11(a) und (b) zeigen Porendurchmesserverteilungen des porösen, zylindrischen Substrates nach Infiltration mit Methanpartialdrücken von 2,5 und 10 kPa. Im letzteren Fall wurde die Infiltration bis nahe an die maximale relative Massenzunahme untersucht. Das Restporenvolumen beträgt 10 % (Figur 11(b)). Ein direkter Vergleich mit Figur 11(a) ist nicht möglich, da bei 2,5 kPa die Infiltration vor Erreichen der möglichen maximalen relativen Massenzunahme abgebrochen wurde. Dennoch ist der Effekt des höheren Methanpartialdruckes beeindruckend, da die Infiltrationszeiten etwa gleich waren. Bemerkenswert ist jedoch das durch die Infiltration entstandene Mikroporenvolumen bei Porendurchmessern kleiner 0,1 µm, das bei weiterer Infiltration nicht mehr infiltrierbar ist. Es beträgt im Falle des kleinen Methanpartialdruckes von 2,5 kPa 0,095 $cm^3$/g, im Falle des großen Methanpartialdruckes von 10 kPa, dagegen nur 0,063 $cm^3$/g, obwohl in diesem letzteren Fall die Porenfüllung nahezu abgeschlossen ist. Daraus folgt, daß bei dem kleinen Methanpartialdruck Poren früher verschlossen werden als bei dem höheren Methanpartialdruck. Die

Vorteile der Verwendung hoher Methanpartialdrücke im Rahmen der erfindungsgemäßen Lehre werden dadurch deutlich. Im übrigen zeigt die Porendurchmesserverteilung des mit 15 kPa Methanpartialdruck infiltrierte Zylinders ein noch geringeres Mikroporenvolumen von 0,59 $cm^3/g$.

Untersuchungsbeispiel 2:

Bei diesem Beispiel werden die Ergebnisse von Untersuchungen mit reinem Methan bei steigendem Gesamtdruck erläutert. Die Infiltrationsbedingungen waren ansonsten dieselben wie in Untersuchungsbeispiel 1, d.h. die Temperatur beträgt 1100°C, die Verweilzeit des Gases 0,16 s.

Figur 12 zeigt die relativen Massezunahmen in Abhängigkeit von der Infiltrationsdauer für Methanpartialdrükke von 20, 30, 50, 100 kPa. Die Kurven wurden mit Hilfe von Gl. (13) gezeichnet. Auf eine maximale Infiltration wurde in Anbetracht der Eindeutigkeit der Ergebnisse verzichtet. Sie dokumentieren, daß mit steigenden Methanpartialdrükken eine noch schnellere Infiltration gelingt, und daß auch unter diesen Bedingungen eine befriedigende oder nahezu maximale Porenfüllung erreichbar ist.

Bei dem Versuch mit 100 kPa Methan wurde nach 7 Stunden Infiltrationszeit Soot-Bildung beobachtet. Dieses Ergebnis überrascht nicht, da zu diesem Zeitpunkt die Porosität weitgehend abgebaut und damit die Oberfläche für die Abscheidung zu klein geworden war. Will man die hohe Infiltrationsgeschwindigkeit bei 100 kPa Methan nutzen, so muß mit fortschreitender Infiltration entweder der Druck reduziert oder die Temperatur abgesenkt werden. Jedenfalls zeigen die Ergebnisse, daß auch bei 50 kPa Methanpartialdruck unter diesen Bedingungen eine maximale Porenfüllung in weniger als 40 Stunden erreichbar ist. Bei 20 kPa Methanpartialdruck wären hierzu etwa 60 Stunden erforderlich.

Untersuchungsbeispiel 3:

Bei dem Untersuchungsbeispiel 3 wird, wie gemäß einer bevorzugten Ausführungsform der Erfindung gelehrt, ein Eduktgasgemisch verwendet, das Wasserstoff aufweist. Dabei wird eine Kreislaufführung des Gases realisiert. Die folgenden Ergebnisse demonstrieren den äußerst positiven Effekt des Wasserstoffes in bezug auf eine maximale Porenbefüllung.

Die Versuche wurden bei einem Gesamtdruck von 20 kPa und unter Verwendung von Methan/Argon/Wasserstoff-Gemischen bei einem konstanten Wasserstoffpartialdruck von 2,5 kPa durchgeführt. Die Reaktionstemperatur betrug 1100°C, die Verweilzeit 0,16s.

Figur 13 zeigt die relativen Massezunahmen des porösen zylindrischen Substrates in Abhängigkeit von der Infiltrationszeit. Es ist offensichtlich, daß die Infiltrationsgeschwindigkeit mit steigendem Methanpartialdruck ansteigt. Dies bedeutet, daß das optimale Ergebnis bei einem Methanpartialdruck von 17,5 kPa und einem Wasserstoffpartialdruck von 2,5 kPa erzielt wird, d.h. in Abwesenheit des "Inertgases" Argon.

Figur 14 zeigt die Anfangsgeschwindigkeit der Infiltration $[d(\Delta m/m_0)/dt]_{t=0}$ in Ab-hängigkeit vom Methanpartialdruck. Das Ergebnis ist ähnlich wie dasjenige in Figur 7. Bei dem höchsten Methanpartialdruck wird nahezu Sättigungsadsorption erreicht; die Infiltrationsgeschwindigkeit ist formal von nullter Ordnung.

Die Figuren 15 und 16 zeigen ergänzend die maximale mögliche relative Massezunahme in Abhängigkeit vom Methanpartialdruck (Figur 15) und von der Anfangsgeschwindigkeit der Infiltration (Figur 16). Die Abhängigkeiten unterscheiden sich von den Ergebnissen ohne Wasserstoff (Figuren 9 und 10). Sie dokumentieren aber eindeutig die erfindungsgemäß gelehrte Bedeutung höherer Methanpartialdrücke und höherer Infiltrationsgeschwindigkeiten und widerlegen damit die allgemeine Auffassung in der Technik und der Literatur (siehe vorne). Die günstige Wirkung der Beigabe von Wasserstoff wird anhand des Ergebnisses der Porendurchmesserverteilung bestätigt. Untersucht wurde der Zylinder, der mit einem Gemisch Methan/Argon/Wasserstoff 15/2,5/2,5 kPa infiltriert wurde (Figur 17). Seine effektive Restporosität beträgt nur 9,6%, das Mikroporenvolumen mit Porendurchmessern kleiner als 0,1µm nur 0,046$cm^3/g$. Dieses Ergebnis wird gerade durch die erfindungsgemäß gelehrte Beigabe von Wasserstoff erhalten.

Durch den Wasserstoff wird die Abscheidung von Kohlenstoff und damit die Infiltrationsgeschwindigkeit erniedrigt, ein aus der Literatur bekanntes Phänomen. Um diese Erniedrigung zu kompensieren, werden erfindungsgemäß Methan/Wasserstoff-Gemische mit höherem Gesamtdruck verwendet. Das Ergebnis von Ausführungsformen des Verfahrens mit einem Gesamtdruck von 50 kPa mit einem Methan/Wasserstoff-Gemisch der Zusammensetzung 43,75/6,25 kPa zeigt Figur 18. Der Kurvenverlauf wurde mit Gl. (13) gezeichnet. Bei diesem Gesamtdruck ist die Infiltration bereits nach etwa 40 Stunden abgeschlossen. Bei gleichem Methan/Wasserstoff-Verhältnis von 7:1, aber einem Gesamtdruck von 20 kPa, ist hierfür etwa die doppelte Zeit von ca. 80 Stunden erforderlich (Figur 18). Dieses Ergebnis unterstreicht erneut den überragenden Vorteil hoher Drücke und widerlegt sowohl die Auffassung in der Technik als auch in der Literatur.

Untersuchungsbeispiel 4:

Nachdem in Untersuchungsbeispiel 3 der günstige Effekt von Wasserstoffbeimengung auf den Porenfüllungsgrad bei der chemischen Gasphaseninfiltration von Kohlenstoff gezeigt wurde, hat sich bei dem Untersuchungsbeispiel 4 der positive Effekt des Beimengens von Wasserstoff zur Erreichung der erfindungsgemäß gelehrten Sättigungsadsorptionsbedingungen, die für das Verfahren essentiell sind, bestätigt. Ergebnisse analog zu Untersuchungsbeispiel 2, die mit reinem Methan bei steigendem Gesamtdruck erhalten wurden, werden mit Ergebnissen verglichen, die mit einem Gemisch aus Methan und Wasserstoff mit dem molaren Verhältnis 6:1 bei steigendem Gesamtdruck und sonst gleichen Bedingungen erzielt wurden.

Zur Dokumentation der Sättigungsadsorption werden wieder die Anfangsgeschwindigkeiten der relativen Massezunahme benutzt. Diese sind in Figur 19 dargestellt. Im Falle der Verwendung von reinem Methan wird der Bereich der Sättigungsadsorption bei einem Druck von etwa 50 kPa erreicht, der abhängig von der Dicke der zu infiltrierenden Teile bzw. der porösen Strukturen zu hoch sein könnte. Verwendet man dagegen ein Methan/Wasserstoff-Gemisch mit einem Wasserstoffanteil von weniger als 15%, so wird der der Sättigungsadsorption entsprechende Bereich bereits bei einem Partialdruck des Methans von 25 bis 30 kPa erreicht.

Bevorzugte Ausführungsformen der Erfindung werden, ggf. in Verbindung mit der Zeichnung, beschrieben.

Ausführungsbeispiel 1:

Verfahren zur chemischen Gasphaseninfiltration von refraktären Stoffen wie C oder SiC dienen in erster Linie der Herstellung von faserverstärkten Verbundwerkstoffen, für die in der englischsprachigen Literatur der Begriff Ceramic Matrix Composites (CMC) üblich ist. Von daher wird eine bevorzugte Ausführungsform der Erfindung zur Herstellung eines kohlenstoff-faserverstärkten Kohlenstoffs durch chemische Gasphaseninfiltration von Kohlenstoff in einer Kohlenstoff-Faserstruktur beschrieben:

Als Kohlenstoff-Faserstruktur wird ein Filz verwendet. Die Struktur hat einen Durchmesser von 36,5 mm und eine Dicke von 20 mm, was einem Volumen von ca. 19 $cm^3$ entspricht. Das Ausgangsgewicht beträgt 3,8 g. Unter Zugrundelegen einer Dichte der Kohlenstoff-Fasern von ca. 1,8 $g/cm^3$ nehmen die Fasern ein Volumen von ca. 2 $cm^3$ ein. Das freie Porenvolumen vor Beginn der Infiltration beträgt somit ca. 17 $cm^3$.

Die Infiltration wird wie folgt durchgeführt:

Gesamtdruck $p_{total}$ = 20 kPa, Temperatur T = 1100 C°, Verweilzeit des Gases in der Reaktionszone $\tau$ = 0,33 s. Als Gas wird ein Gemisch aus Methan und Wasserstoff im molaren Verhältnis von 7:1 benutzt. Die Bedingungen sind darauf abgestellt, eine möglichst vollständige Infiltration in einer vertretbaren Zeit zu erreichen. Unter diesen Bedingungen werden ca. 10 % des mit dem Eduktgas Methan zugeführten Kohlenstoffs in der porösen Struktur abgeschieden. Der Einbau der Faserstruktur in den Reaktor erfolgt mit Hilfe eines Einbauteiles von 2 cm Dicke gemäß Figur 1. Zwischen Einbauteil und seitlichen Begrenzungsrändern ist ein Spalt von 2 mm Weite vorgesehen.

Nach 6 Tagen kontinuierlicher Infiltration weist die infiltrierte Faserstruktur ein Gewicht von 36,1 g auf. Unter Berücksichtigung einer Dichte des abgeschiedenen Kohlenstoffs von 2,07 $g/cm^3$ ergibt sich ein Porenfüllungsgrad von über 92 % bzw. eine Restporosität von weniger als 8 %. Die mittlere Dichte beträgt 1,9 $g/cm^3$. Ähnliche Werte werden mit Verfahren gemäß dem Stand der Technik in keinem Fall, auch nicht nach wochen- bzw. monatelanger Infiltration erreicht, wobei erschwerend hinzukommt, dass die Infiltrationsprozesse nach dem Stand der Technik mehrfach unterbrochen werden müssen, um die Oberflächen mechanisch zu reinigen.

Ausführungsbeispiel 2:

Es wird eine Infiltration von C mit technisch reinem Methan durchgeführt. Der Totaldruck beträgt 20 kPa, die Temperatur beträgt 1.100 °C, die Verweildauer $\tau$ wird auf 0,16 s eingestellt. Die Beströmung der porösen Struktur erfolgt über Spalte einer Spaltweite von 2 mm. Ab einer Spaltweite von 50 mm abwärts werden mit den erfindungsgemäß gelehrten hohen Drücken im Bereich der Sättigungsadsorption überhaupt brauchbare Porenfüllungen erzielt. Ab einer Spaltweite von 25 mm abwärts werden mit den erfindungsgemäß gelehrten hohen Drücken im Bereich der Sättigungsadsorption Porenfüllungen erzielt, die besser sind als bei herkömmlichen Verfahren. In einem Bereich von 1 bis 5 mm werden, wie bei dem vorliegenden Ausführungsbeispiel mit 2 mm, beste Ergebnisse hinsichtlich Porenfüllung und Fertigungsgeschwindigkeit erzielt. Die Spaltbreiten werden oberhalb 1 mm gewählt, um isobare Druckverhältnisse bei kurzen Verweilzeiten zu ermöglichen. Sofern sich isobare Druckverhältnisse auch bei kleineren Spaltweiten realisieren lassen, können die Spaltweiten ggf. auch geringer als 1 mm sein.

Ausführungsbeispiel 3:

Es werden folgende Infiltrationsbedingungen eingehalten:

| | |
|---|---|
| Temperatur T = | 1.100 °C |
| Gesamtdruck $p_{total}$ = | 26 kPa bis 100 kPa |
| Beströmung mit reinem Methan | |
| Verweilzeit $\tau$ = | 0,16 s. |

Wie aus Fig. 12 hervorgeht, wird im Bereich der bei diesem Ausführungsbeispiel eingestellten Drücke bereits nach 50 Stunden die maximal erreichbare Porenfüllung erreicht, was einer vertretbaren Fertigungsdauer entspricht.

Ausführungsbeispiel 4:

Es werden die folgenden Infiltrationsbedingungen für die Infiltration von C eingehalten:

| | |
|---|---|
| Temperatur T = | 1.100 °C |
| Gesamtdruck $p_{total}$ = | 26 kPa bis 50 kPa |
| Verweilzeit $\tau$ = | 0,16 s bis 0,33 s |
| Partialdruck $P_{CH4}$ = | 7/8 $p_{total}$ |
| Partialdruck $P_{H2}$ = | 1/8 $p_{total}$ |

Wie aus Fig. 18 ersichtlich ist, wird bei diesen Verfahrenbedingungen bereits nach 30 Stunden Infiltration ein Porenfüllungsgrad erreicht, der nahe an der maximal erreichbaren Porenfüllung liegt.

Ausführungsbeispiel 5:

Es wird mit den im Zusammenhang mit den Figuren 6 und 9 verwendeten Infiltrationsbedingungen eine Infiltration von C durchgeführt. D.h. es wird ein Methan/Argon-Gemisch verwendet. Dabei wird mit Methanpartialdrücken gearbeitet, die dem Bereich der in Figur 9 gezeigten Kurve entsprechen, in dem gute Porenfüllungsgrade erreicht werden, d.h. oberhalb von 10 kPa. Unter Einstellen der Verweilzeit werden dabei Abscheidungsraten von 10 % bis 25 % eingehalten.

Ausführungsbeispiel 6:

Es wird mit den gleichen Infiltrationsbedingungen gearbeitet, wie im Ausführungsbeispiel 5. Jedoch liegt der Methanpartialdruck in dem Bereich, in dem die aus Figur 14 ersichtliche Kurve der relativen Massenzunahme einen abgeflachten Verlauf nimmt, d.h. oberhalb von 15 kPa.

Ausführungsbeispiel 7:

Es wird zur Kohlenstoffinfiltration mit einer Mischung von Methan und Wasserstoff im Verhältnis 6 : 1 gearbeitet. Die Temperatur beträgt 1080 °C. Die Verweilzeit liegt abgestimmt auf den Druck zwischen 0,01 und 0,9 s. Der Methanpartialdruck wird in einem Bereich eingestellt, in dem in der aus Figur 19 ersichtlichen Kurve eine Abflachung auftritt, die das Vorliegen von Bedingungen im Bereich der Sättigungsadsorption kennzeichnet. Es wird daher ein Druck von größer als 15 kPa und kleiner 30 kPa, oder bei einem Arbeitsgang zum Einhalten besonders schneller Fertigungsgeschwindigkeiten von 25 kPa bis 50 kPa eingehalten.

Ausführungsbeispiel 8:

Es wird mit den gleichen Infiltrationsbedingungen gearbeitet wie in einem der vorbeschriebenen Ausführungsbeispiele mit dem Unterschied, daß Methan von Methyltrichlorsilan und Wasserstoff von Chlorwasserstoff ersetzt ist und die eingestellte Prozeßtemperatur auf ca. 1000 °C eingestellt wird.

**Patentansprüche**

1. Verfahren zu einer auf Diffusion in der porösen Struktur basierenden isothermen und isobaren chemischen Gasphaseninfiltration von refraktären Stoffen, insbesondere von Kohlenstoff (C) und Siliciumcarbid (SiC), bei dem in einer Reaktionszone eine poröse Struktur mit einem Gas beströmt wird, wobei

    a) bei gegebener Temperatur in der Reaktionszone der Druck des Gases bzw. der Partialdruck eines in dem Gas enthaltenen Eduktgases und die Verweilzeit des Gases in der Reaktionszone derart eingestellt werden, daß

        a1) in der porösen Struktur eine Abscheidungsreaktion im Druck- bzw. Partialdruckbereich der Sättigungsadsorption erfolgt, wobei Sättigungsadsorption bedeutet, daß bei einer Erhöhung des Gasdruckes bzw. des Partialdruckes des Eduktgases die Abscheidungsgeschwindigkeit im wesentlichen konstant bleibt bzw. unwesentlich erhöht wird, und
        a2) die Umsetzung des Eduktgases in jedem Stadium der Infiltration so begrenzt wird, daß beim Durchströmen der Reaktionszone nicht mehr als 50 %, vorzugsweise 10 % bis 25 %, der im Eduktgas zugeführten, die feste Phase bildenden Elemente als feste Phase in der porösen Struktur abgeschieden werden, und

    b) die Beströmung der porösen Struktur geradlinig von unten nach oben durch Spalten im wesentlichen gleicher Weite von 1 bis 50 mm, vorzugsweise weniger als 25 mm, erfolgt.

2. Verfahren nach Anspruch 1, wobei für die Gasphaseninfiltration von C in der Reaktionszone Temperaturen im Bereich von 1000 bis 1200°C eingestellt werden.

3. Verfahren nach Anspruch 1, wobei für die Gasphaseninfiltration von SiC in der Reaktionszone Temperaturen im Bereich von 900 bis 1100°C eingestellt werden.

4. Verfahren nach einem der Ansprüche 1 bis 4, bei dem dem Gas, mit dem die poröse Struktur beströmt wird, kein Inertgas wie Argon, Stickstoff oder dergleichen beigemischt wird.

5. Verfahren nach einem der Ansprüche 1, 2 oder 4, wobei für die Gasphaseninfiltration von C als Eduktgas Erdgas, vorzugsweise Methan, verwendet wird.

6. Verfahren nach einem der Ansprüche 1, 3 oder 4, wobei für die Gasphaseninfiltration von SiC als Eduktgas Methyltrichlorsilan, vorzugsweise ein Gemisch aus Methyltrichlorsilan und Wasserstoff, verwendet wird.

7. Verfahren nach Anspruch 6, wobei das molare Verhältnis von Methyltrichlorsilan und Wasserstoff 1 : 1 bis 1 : 100, vorzugsweise 1 : 2 bis 1 : 10 beträgt.

8. Verfahren nach einem der Ansprüche 1 bis 7, wobei die poröse Struktur mit einem Gas beströmt wird, das ein bei der Gasphaseninfiltration entstehendes Nebenprodukt aufweist.

9. Verfahren nach Anspruch 8, wobei für die Gasphaseninfiltration von C dem Eduktgas Wasserstoff beigemischt wird.

10. Verfahren nach Anspruch 9, wobei das Volumenverhältnis von Methan bzw. Erdgas und beigemischtem Wasserstoff 20 : 1 bis 2 : 1, vorzugsweise 10 : 1 bis 5 : 1 beträgt.

11. Verfahren nach Anspruch 8, wobei für die Gasphaseninfiltration von SiC dem Eduktgas Chlorwasserstoff beigemischt wird.

12. Verfahren nach Anspruch 11, wobei das molare Verhältnis von Methyltrichlorsilan und beigemischtem Chlorwasserstoff 5 : 1 bis 1:5, vorzugsweise 3 : 1 bis 1 : 2 beträgt.

13. Verfahren nach einem der Ansprüche 1 bis 12, wobei mit fortschreitender Infiltrationsdauer

    a) der Druck bzw. der Partialdruck des Eduktgases und/oder
    b) die Temperatur

in der Reaktionszone kontinuierlich oder stufenweise abgesenkt wird.

**14.** Verfahren nach einem der Ansprüche 1 bis 13, wobei die Aufheizung der Reaktionszone nach dem Heißwandreaktorprinzip erfolgt.

**15.** Verfahren nach Anspruch 14, wobei die Reaktionszone jeweils in einem vertikalen Teilabschnitt der Reaktionszone beheizt wird, wobei der vertikale Teilabschnitt mit fortschreitender Infiltrationsdauer kontinuierlich oder schrittweise über die Reaktionszone hin von unten nach oben verlagert wird.

**16.** Verfahren nach einem der Ansprüche 1 bis 15, bei dem die poröse Struktur in einem die Reaktionszone bildenden Reaktorinnenraum derart angebracht wird, daß der Reaktorinnenraum in jeder Höhe nicht von der porösen Struktur eingenommene freie Durchströmquerschnitte aufweist, die der Querschnittsgeometrie der porösen Struktur derart angepaßt ausgebildet sind, daß entlang der Kontur der porösen Struktur Spalte im wesentlichen gleicher Spaltweite gebildet werden und der Reaktorinnenraum über einen an dessen unterem Ende angeschlossenen Gaseinlaß und einem und einen an dessen oberem Ende angeschlossenen Gasauslaß vertikal durchströmt wird.

**17.** Verfahren nach Anspruch 16, wobei in dem Reaktorinnenraum ein an die Gestalt der porösen Struktur angepaßt ausgebildetes Einbauteil derart angebracht wird, daß es in der Reaktionszone Bereiche einnimmt, die nicht von der porösen Struktur eingenommen sind, und in jeder Höhe ein nicht von der porösen Struktur bzw. dem Einbauteil eingenommener freier spaltförmiger über die Höhe der Reaktionszone konstanter Strömungsquerschnitt verbleibt.

**18.** Verfahren nach Anspruch 16 oder 17, wobei der Reaktorinnenraum jeweils nur in einem Abschnitt der Reaktionszone beheizt wird und der beheizte Abschnitt schrittweise oder kontinuierlich von unten nach oben verlagert wird.

**19.** Verfahren nach einem der Ansprüche 1 bis 15, wobei die poröse Struktur mit dem Gas in einer solchen Reaktionszone beströmt wird, die stationär ist, und die poröse Struktur kontinuierlich oder schrittweise der stationären Reaktionszone zugeführt und durch diese hindurchbewegt wird.

**20.** Verfahren nach einem der Ansprüche 1 bis 19, wobei das Gas im Kreislauf geführt wird.

**21.** Verfahren nach Anspruch 20, wobei ein Anteil des die Reaktionszone verlassenden Gases ausgeschleust und durch Eduktgas ersetzt wird.

**22.** Verfahren nach Anspruch 21, wobei von dem die Reaktionszone verlassenden Gas flüchtige Zwischenprodukte der chemischen Gasphasenabscheidung abgetrennt werden, bevor der Anteil des Gases ausgeschleust und durch Eduktgas ersetzt wird.

**23.** Verfahren nach Anspruch 22, wobei die flüchtigen Zwischenprodukte der chemischen Gasphasenabscheidung von dem die Reaktionszone verlassenden Gas in einer Wirbelschicht durch Zersetzung bei einer Temperatur unterhalb der Temperatur in der Reaktionszone abgetrennt werden.

**24.** Faserverstärkter Verbundwerkstoff mit einer Matrix aus refraktären Stoffen, insbesondere einer C- oder SiC-Matrix, der durch die chemische Gasphaseninfiltration nach einem der Ansprüche 1 bis 23 ohne weitere Verdichtungsbehandlung, wie z.B. Heißpressen, hergestellt ist und bei einer Materialstärke von mehr als 8 mm, vorzugsweise mehr als 15 mm, einen Porenfüllungsgrad von mehr als 88 %, vorzugsweise mehr als 90 %, entsprechend einer Porösität kleiner 12, vorzugsweise kleiner 10 %, aufweist.

**25.** Faserverstärkter Keramikmatrix-Verbundwerkstoff nach Anspruch 24, dessen Schliffbild unter dem Auflichtmikroskop eine homogene Struktur ohne erkennbare Zonen unterschiedlicher Struktur aufweist.

**26.** Faserverstärkter Keramikmatrix-Verbundwerkstoff nach Anspruch 24 oder 25, der eine Kohlenstoff-Matrix mit einer homogen isotropen Struktur aufweist.

**27.** Faserverstärkter Keramikmatrix-Verbundwerkstoff nach Anspruch 24 oder 25, der eine Kohlenstoff-Matrix mit einer homogen lamellaren Struktur aufweist.

**28.** Bremsscheibe aus einem faserverstärkten Verbundwerkstoff mit einer Matrix aus refraktären Stoffen, insbesondere einer C- oder SiC-Matrix, die durch die chemische Gasphaseninfiltration nach einem der Ansprüche 1 bis 23 ohne

weitere Verdichtungsbehandlung, wie z.B. Heißpressen, hergestellt ist und bei einer Materialstärke von mehr als 8 mm, vorzugsweise mehr als 15 mm, einen Porenfüllungsgrad von mehr als 88 %, vorzugsweise mehr als 90 %, entsprechend einer Porösität kleiner 12, vorzugsweise kleiner 10 %, aufweist.

**29.** Knochen- bzw. Gelenkprothese aus einem faserverstärkten Verbundwerkstoff mit einer Matrix aus refraktären Stoffen, insbesondere einer C- oder SiC-Matrix, die durch die chemische Gasphaseninfiltration nach einem der Ansprüche 1 bis 23 ohne weitere Verdichtungsbehandlung, wie z.B. Heißpressen, hergestellt ist und bei einer Materialstärke von mehr als 8 mm, vorzugsweise mehr als 15 mm, einen Porenfüllungsgrad von mehr als 88 %, vorzugsweise mehr als 90 %, entsprechend einer Porösität kleiner 12 %, vorzugsweise kleiner 10 %, aufweist.

## Claims

**1.** A method based on diffusion in porous structure for isothermic and isobaric chemical vapor infiltration of refractory materials, especially of carbon (C) and silicon carbide (SiC), wherein a porous structure is treated with a flow of gas in a reaction zone, wherein

(a) at a given temperature in the reaction zone the pressure of the gas or the partial pressure of an educt gas contained in the gas and the persistence time of the gas in the reaction zone is adjusted such that

(a1) a deposition reaction takes place in the porous structure in the region of said pressure or partial pressure region, respectively, of the saturation adsorption, whereby saturation adsorption means that upon raising said gas pressure or said partial pressure of the educt gas, respectively, the deposition rate remains substantially constant or is negligibly increased, and
(a2) the transformation of the educt gas in every stage of the infiltration is limited such that by flow through in the reaction zone not more than 50%, preferably 10% to 25% of the elements which form the solid phase and which are carried in the educt gas are deposited in the porous structure, and

(b) the treatment of the porous structures with a flow of gas occurs in a linear fashion from bottom to top through apertures of substantially identical width from 1 to 50 mm, preferably less than 25 mm.

**2.** The method according to claim 1, wherein for the vapor infiltration of C the temperature in the reaction zone is adjusted to lie in the range of 1,000 to 1,200 °C.

**3.** The method according to claim 1, wherein for the vapor infiltration of SiC the temperature in the reaction zone is adjusted to lie in the range of 900 to 1,100 °C.

**4.** The method according to any of claims 1 to 4, wherein the gas with which the porous structure is flow-treated is not mixed with any inert gas such as argon, nitrogen or the like.

**5.** The method according to any of claims 1, 2 or 4, wherein natural gas, preferably methane, is used as educt gas for the vapor infiltration of C.

**6.** The method according to claims 1, 3 or 4, wherein methyltrichlorosilane, preferably a mixture of methyltrichlorosilane and hydrogen, is used as educt gas for the vapor infiltration of SiC.

**7.** The method according to claim 6, wherein the molar ratio of methyltrichlorosilane to hydrogen is 1 : to 1 : 100, preferably 1 : 2 to 1 : 10.

**8.** The method according to any of claims 1 to 7, wherein the porous structure is flow-treated with a gas which comprises a byproduct generated during vapor infiltration.

**9.** The method according to claim 8, wherein, for the vapor infiltration of C, hydrogen is mixed with the educt gas.

**10.** The method according to claim 9, wherein the volume ratio of methane or natural gas to hydrogen which is mixed therein is 20 : 1 to 2 : 1, preferably 10 : 1 to 5 : 1.

**11.** The method according to claim 8, wherein, for the vapor infiltration of SiC, hydrogen chloride is mixed with the

educt gas.

**12.** The method according to claim 11, wherein the molar ratio of methyltrichlorosilane to hydrogen chloride mixed therein is 5 : 1 to 1 : 5, preferably 3 : 1 to 1 : 2.

**13.** The method according to any of claims 1 to 12, wherein with progressive infiltration time

a) the pressure or the partial pressure of the educt gas and/or
b) the temperature

in the reaction zone is continually or stepwise reduced.

**14.** The method according to any of claims 1 to 13, wherein heating of the reaction zone occurs according to the principle of hot-walled reactors.

**15.** The method according to claim 14, wherein the reaction zone is heated in a respective vertical segment of the reaction zone, wherein with progressive infiltration time the vertical segment is shifted continually or stepwise over the reaction zone from bottom to top.

**16.** The method according to any of claims 1 to 15, wherein the porous structure is arranged in such a way within a reactor interior forming the reaction zone that the reactor interior exhibits, at every height, free flow-through cross-sections not taken up by the porous structure, which free flow-through cross-sections are formed to correspond to the cross-sectional geometry of the porous structure in such a way that, along the contour of the porous structure, gaps of substantially constant gap width are formed and the reactor interior is subjected to a flow-through via a gas inlet connected at its bottom end and a gas outlet connected at its upper end.

**17.** The method according to claim 16, wherein in the reactor interior a mounting formed to the shape of the porous structure is situated such that it occupies regions in the reaction zone which are not occupied by the porous structure, and in every height there remains a free, gapped flow-through cross section, constant throughout the height of the reaction zone, which is not occupied by the porous structure or by the mounting.

**18.** The method according to claim 16 or 17, wherein the reactor interior is heated in a single respective reaction region and the heated region is either stepwise or continually shifted from bottom to top.

**19.** Method according to any of claims 1 through 15, wherein the porous structure is flow-treated with the gas in such a reaction zone, which is stationary, and the porous structure is brought continually or stepwise into the stationary reaction zone and is moved through it.

**20.** The method according to any of claims 1 through 19, wherein the gas is circulated.

**21.** The method according to claim 20, wherein a portion of the gas leaving the reaction zone is led away and is replaced with educt gas.

**22.** The method according to claim 21, wherein the volatile intermediates of the chemical vapor deposition are separated from the gas leaving the reaction zone, before the portion of this gas is led away and is replaced with educt gas.

**23.** The method according to claim 22, wherein the volatile intermediates of the chemical vapor deposition are separated from the gas leaving the reaction zone in a vortex layer by decomposition at a temperature below the temperature in the reaction zone.

**24.** A Fiber-reinforced composite material with a matrix made of refractory materials, in particular a C- or a SiC-Matrix, which is produced by the chemical vapor infiltration according to any of claims 1 to 23 without further densification treatment, e.g. heat pressing, and which exhibits a material strength of more than 8 mm, preferably more than 15 mm, a pore filling degree of more than 88%, preferably more than 90%, corresponding to a porosity of less than 12, preferably less than 10%.

**25.** Fiber-reinforced ceramic matrix composite material according to claim 24, whose micrograph under the vertical

illumination microscope exhibits a homogeneous structure without zones of varying structure.

**26.** Fiber-reinforced ceramic matrix composite material according to claim 24 or 25, which exhibits a carbon matrix with a homogeneous isotropic structure.

**27.** Fiber-reinforced ceramic matrix composite material according to claim 24 or 25, which exhibits a carbon matrix with a homogeneous lamellar structure.

**28.** A brake pad made of a fiber-reinforced composite material with a matrix of refractory material, in particular a C- or SiC-Matrix, which is produced by the chemical vapor infiltration according to any of claims 1 to 23 without further densification treatment, e.g. heat pressing, and which exhibits a material strength of more than 8 mm, preferably more than 15 mm, a pore filling degree of more than 88%, preferably more than 90%, corresponding to a porosity of less than 12, preferably less than 10%.

**29.** A bone or joint prothesis made of a fiber-reinforced composite material with a matrix of refractory material, in particular a C- or SiC-Matrix, which is produced by the chemical vapor infiltration according to any of claims 1 to 23 without further densification treatment, e.g. heat pressing, and which exhibits a material strength of more than 8 mm, preferably more than 15 mm, a pore filling degree of more than 88%, preferably more than 90%, corresponding to a porosity of less than 12%, preferably less than 10%.

**Revendications**

**1.** Procédé d'infiltration chimique en phase vapeur isotherme et isobare, basée sur la diffusion dans la structure poreuse, de matières réfractaires, notamment de carbone (C) et de carbure de silicium (SiC), dans lequel, dans une zone réactionnelle, on fait passer un flux de gaz dans une structure poreuse, caractérisé en ce que

a) à une température donnée dans la zone réactionnelle, la pression du gaz ou la pression partielle d'un gaz éduit contenu dans le gaz et le temps de séjour du gaz dans la zone réactionnelle sont ajustés de telle sorte que

a1) il se produit dans la structure poreuse une réaction de dépôt dans la plage de pression ou pression partielle de l'adsorption de saturation, l'adsorption de saturation signifiant que, lorsque la pression du gaz ou la pression partielle du gaz éduit augmente, la vitesse de dépôt reste sensiblement constante ou augmente de manière négligeable, et
a2) la conversion du gaz éduit à chaque stade de l'infiltration est limitée de telle sorte que, lorsque la zone réactionnelle est traversée par le flux de gaz, pas plus de 50%, de préférence de 10% à 25% des éléments formant la phase solide introduits dans le gaz éduit sont déposés en tant que phase solide dans la structure poreuse ; et

b) le passage du flux de gaz dans la structure poreuse se fait de manière rectiligne de bas en haut à travers des fentes de largeur sensiblement égale de 1 à 50 mm, de préférence de moins de 25 mm.

**2.** Procédé selon la revendication 1, dans lequel, pour l'infiltration en phase vapeur de C, les températures dans la zone réactionnelle sont ajustées dans la plage de 1000 à 1200°C.

**3.** Procédé selon la revendication 1, dans lequel, pour l'infiltration en phase vapeur de SiC, les températures dans la zone réactionnelle sont ajustées dans la plage de 900 à 1100°C.

**4.** Procédé selon l'une des revendications 1 à 3, dans lequel le gaz que l'on fait passer dans la structure poreuse ne contient aucun gaz inerte tel que l'argon, l'azote ou similaire mélangé.

**5.** Procédé selon l'une des revendications 1, 2 ou 4, dans lequel, pour l'infiltration en phase vapeur de C, on utilise comme gaz éduit un gaz naturel, de préférence du méthane.

**6.** Procédé selon l'une des revendications 1, 3 ou 4, dans lequel, pour l'infiltration en phase vapeur de SiC, on utilise comme gaz éduit du méthyltrichlorosilane, de préférence un mélange de méthyltrichlorosilane et d'hydrogène.

**7.** Procédé selon la revendication 6, dans lequel le rapport molaire du méthyltrichlorosilane sur l'hydrogène est de

1:1 à 1:100, de préférence de 1:2 à 1:10.

**8.** Procédé selon l'une des revendications 1 à 7, dans lequel on fait passer dans la structure poreuse un flux de gaz qui présente un sous-produit généré lors de l'infiltration en phase vapeur.

**9.** Procédé selon la revendication 8, dans lequel, pour l'infiltration en phase vapeur de C, on mélange de l'hydrogène avec le gaz éduit.

**10.** Procédé selon la revendication 9, dans lequel le rapport en volume du méthane ou du gaz naturel sur l'hydrogène mélangé est de 20:1 à 2:1, de préférence de 10:1 à 5:1.

**11.** Procédé selon la revendication 8, dans lequel, pour l'infiltration en phase vapeur de SiC, on mélange du chlorure d'hydrogène avec le gaz éduit.

**12.** Procédé selon la revendication 11, dans lequel le rapport molaire du méthyltrichlorosilane sur le chlorure d'hydrogène mélangé est de 5:1 à 1:5, de préférence de 3:1 à 1:2.

**13.** Procédé selon l'une des revendications 1 à 12, dans lequel, à mesure que la durée d'infiltration se prolonge,

a) la pression ou pression partielle du gaz éduit et/ou
b) la température

dans la zone réactionnelle chutent de manière continue ou par paliers.

**14.** Procédé selon l'une des revendications 1 à 13, dans lequel le chauffage de la zone réactionnelle se fait selon le principe du réacteur à parois chaudes.

**15.** Procédé selon la revendication 14, dans lequel la zone réactionnelle est chauffée à chaque fois par tranche verticale, la tranche verticale se déplaçant de bas en haut de manière continue ou par paliers dans la zone réactionnelle à mesure que la durée d'infiltration se prolonge.

**16.** Procédé selon l'une des revendications 1 à 15, dans lequel la structure poreuse est placée dans l'espace intérieur d'un réacteur formant la zone réactionnelle de façon que l'espace intérieur du réacteur présente à chaque hauteur des sections de passage libre non incluses par la structure poreuse qui sont formées de manière adaptée à la géométrie sectionnelle de la structure poreuse de telle sorte qu'il se forme le long du contour de la structure poreuse des fentes avec une largeur de fente sensiblement égale, et l'espace intérieur du réacteur est traversé verticalement par le flux de gaz par l'intermédiaire d'une entrée de gaz reliée à son extrémité inférieure et d'une sortie de gaz reliée à son extrémité supérieure.

**17.** Procédé selon la revendication 16, dans lequel une pièce incorporée ayant une forme adaptée à la forme de la structure poreuse est placée dans l'espace intérieur du réacteur de façon qu'elle inclue des parties de la zone réactionnelle qui ne sont pas incluses par la structure poreuse et qu'il subsiste à chaque hauteur une section de passage libre en forme de fente, non incluse par la structure poreuse ni par la pièce incorporée, qui est constante sur la hauteur de la zone réactionnelle.

**18.** Procédé selon la revendication 16 ou la revendication 17, dans lequel l'espace intérieur du réacteur est chauffé seulement dans une tranche de la zone réactionnelle et la tranche chauffée se déplace de bas en haut de manière continue ou par paliers.

**19.** Procédé selon l'une des revendications 1 à 15, dans lequel on fait passer un flux de gaz dans la structure poreuse à l'intérieur d'une zone réactionnelle qui est stationnaire et la structure poreuse est amenée dans celle-ci et déplacée à travers elle de manière continue ou par paliers.

**20.** Procédé selon l'une des revendications 1 à 19, dans lequel le gaz est alimenté en circuit fermé.

**21.** Procédé selon la revendication 20, dans lequel une partie du gaz quittant la zone réactionnelle est éclusé au dehors et remplacé par du gaz éduit.

**22.** Procédé selon la revendication 21, dans lequel des produits intermédiaires volatils du dépôt chimique en phase vapeur sont séparés du gaz quittant la zone réactionnelle avant que la partie du gaz soit éclusée au dehors et remplacée par du gaz éduit.

**23.** Procédé selon la revendication 22, dans lequel les produits intermédiaires volatils du dépôt chimique en phase vapeur sont séparés du gaz quittant la zone réactionnelle dans un lit fluidisé par décomposition à une température inférieure à la température de la zone réactionnelle.

**24.** Matériau composite renforcé par des fibres avec une matrice en matériaux réfractaires, notamment une matrice de C ou de SiC, qui est préparé par infiltration chimique en phase vapeur selon l'une des revendications 1 à 23 sans autre traitement de densification, par exemple de compression à chaud, et qui présente pour une épaisseur de matériau supérieure à 8 mm, de préférence supérieure à 15 mm, un degré de remplissage des pores de plus de 88%, de préférence plus de 90%, correspondant à une porosité inférieure à 12%, de préférence inférieure à 10%.

**25.** Matériau composite à matrice céramique renforcée par des fibres selon la revendication 24, dont la coupe micrographique vue au microscope à éclairage incident présente une structure homogène sans zones de structure différente discernables.

**26.** Matériau composite à matrice céramique renforcée par des fibres selon la revendication 24 ou la revendication 25, présentant une matrice en carbone avec une structure isotrope homogène.

**27.** Matériau composite à matrice céramique renforcée par des fibres selon la revendication 24 ou la revendication 25, présentant une matrice en carbone avec une structure lamellaire homogène.

**28.** Disque de frein fait d'un matériau composite renforcé par des fibres avec une matrice en matériaux réfractaires, notamment une matrice de C ou de SiC, qui est préparé par infiltration chimique en phase vapeur selon l'une des revendications 1 à 23 sans autre traitement de densification, par exemple de compression à chaud, et qui présente pour une épaisseur de matériau supérieure à 8 mm, de préférence supérieure à 15 mm, un degré de remplissage des pores de plus de 88%, de préférence plus de 90%, correspondant à une porosité inférieure à 12%, de préférence inférieure à 10%.

**29.** Prothèse osseuse ou articulaire faite d'un matériau composite renforcé par des fibres avec une matrice en matériaux réfractaires, notamment une matrice de C ou de SiC, qui est préparé par infiltration chimique en phase vapeur selon l'une des revendications 1 à 23 sans autre traitement de densification, par exemple de compression à chaud, et qui présente pour une épaisseur de matériau supérieure à 8 mm, de préférence supérieure à 15 mm, un degré de remplissage des pores de plus de 88%, de préférence plus de 90%, correspondant à une porosité inférieure à 12%, de préférence inférieure à 10%.

Reaktorquerschnitt

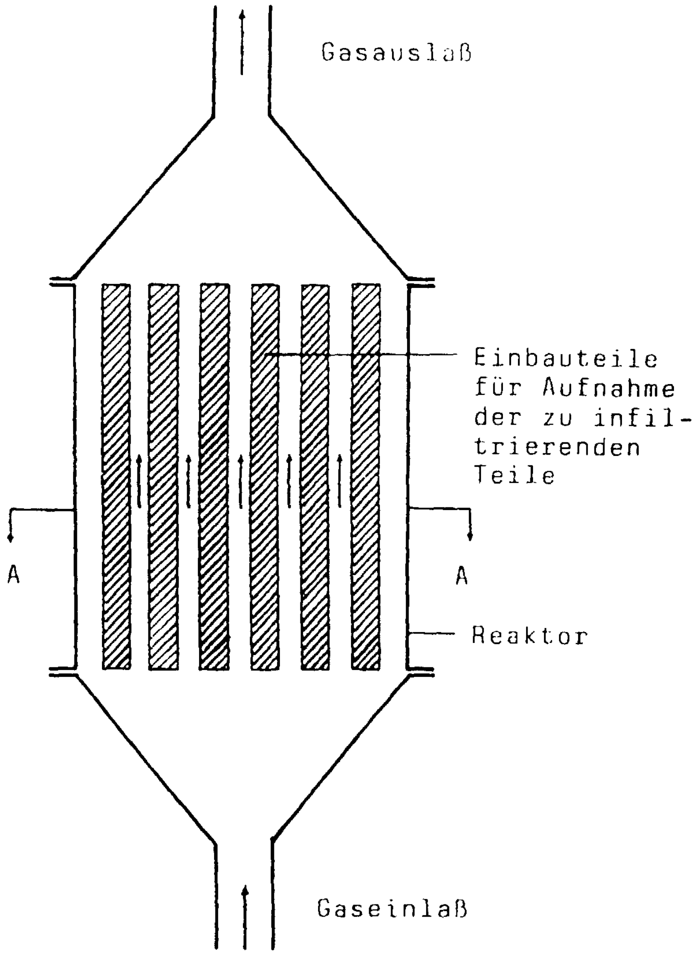


Fig. 1A

Aufsicht auf Einbauteil

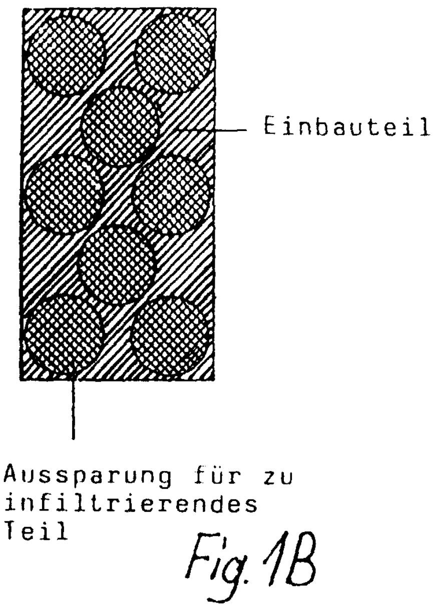


Fig. 1B

Schnitt A-A durch den Reaktor

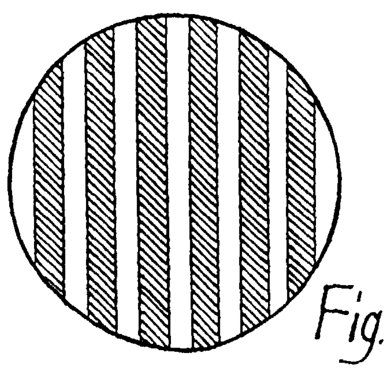

Fig. 1C

Horizontaler Schnitt

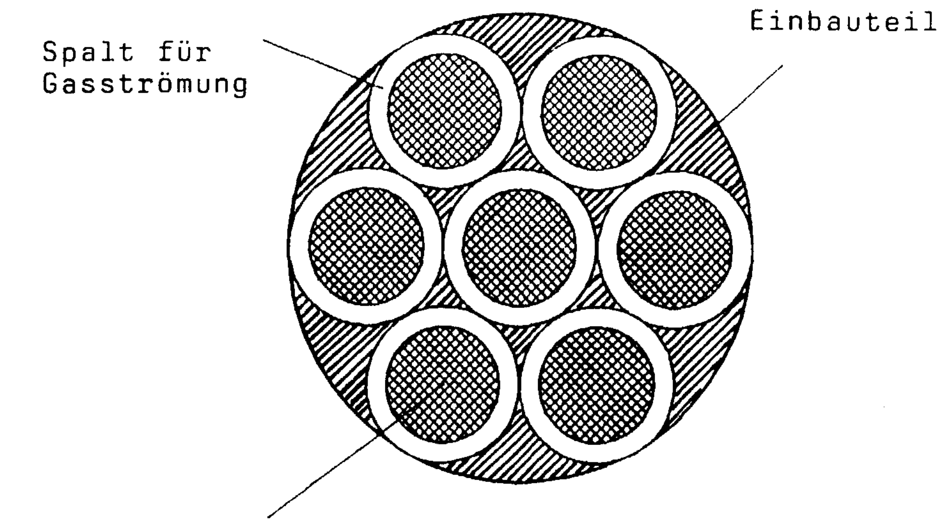


Fig. 2

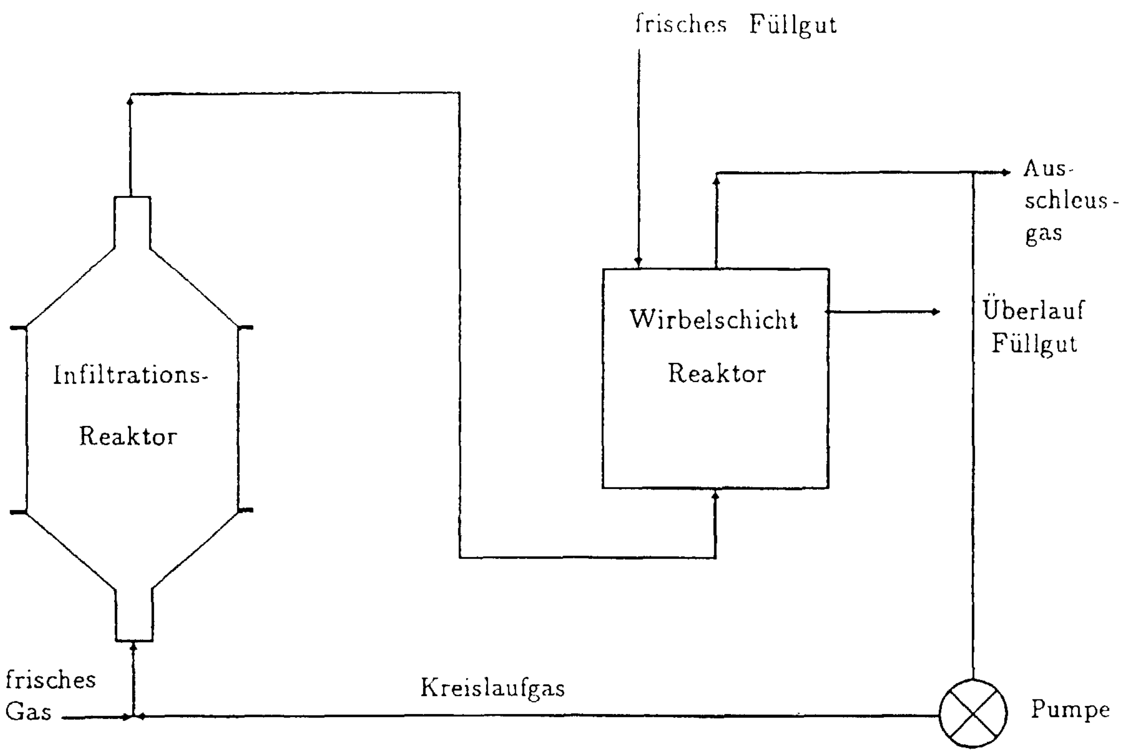
frisches Füllgut
Aus-
schleus-
gas
Wirbelschicht
Reaktor
Überlauf
Füllgut
Infiltrations-
Reaktor
frisches
Gas
Kreislaufgas
Pumpe

Fig. 3

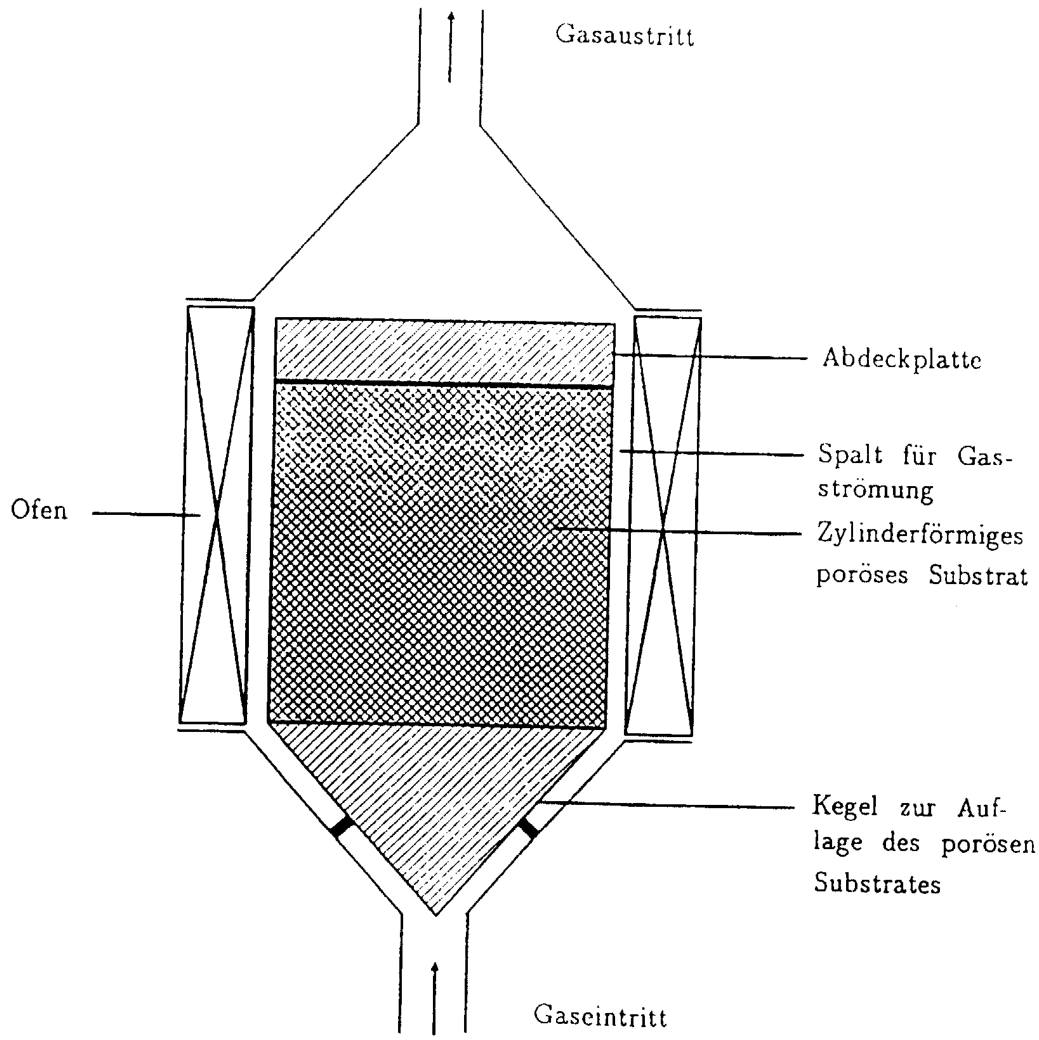
Gasaustritt
Abdeckplatte
Spalt für Gas-
strömung
Zylinderförmiges
poröses Substrat
Ofen
Kegel zur Auf-
lage des porösen
Substrates
Gaseintritt

Fig. 4

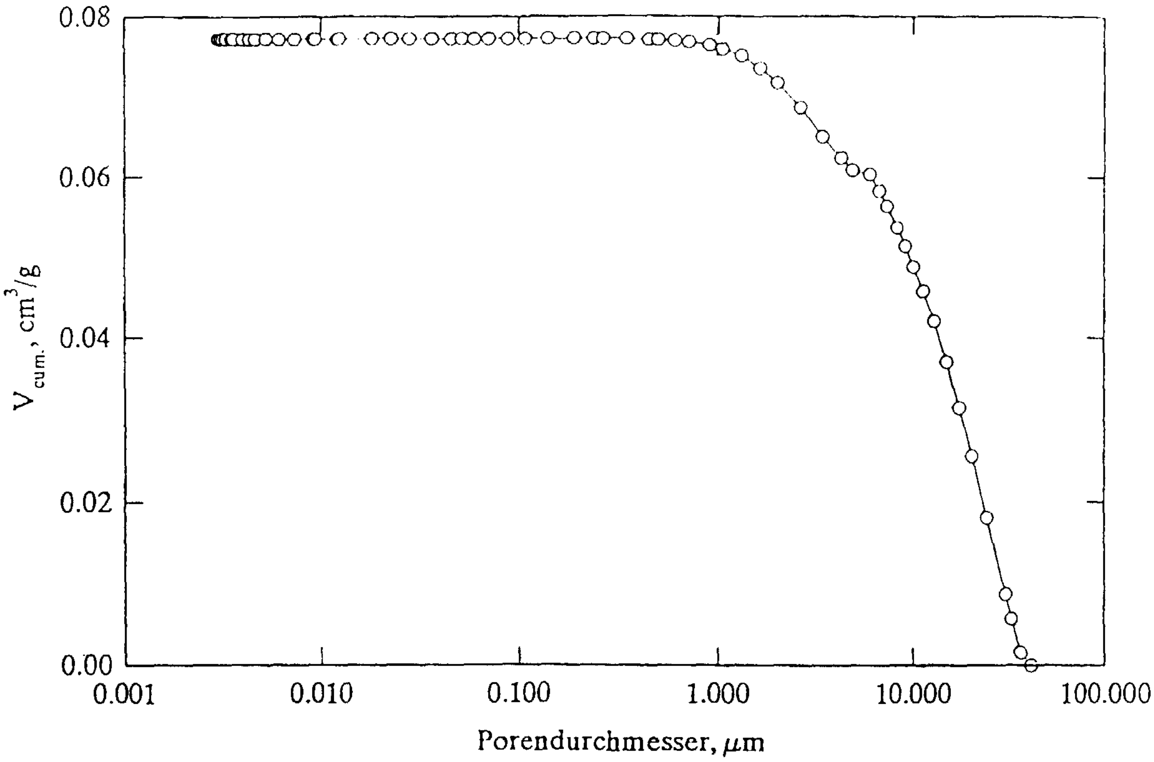
0.08
0.06
0.04
0.02
0.00
V cum., cm3/g
0.001
0.010
0.100
1.000
10.000
100.000
Porendurchmesser, µm

Fig. 5

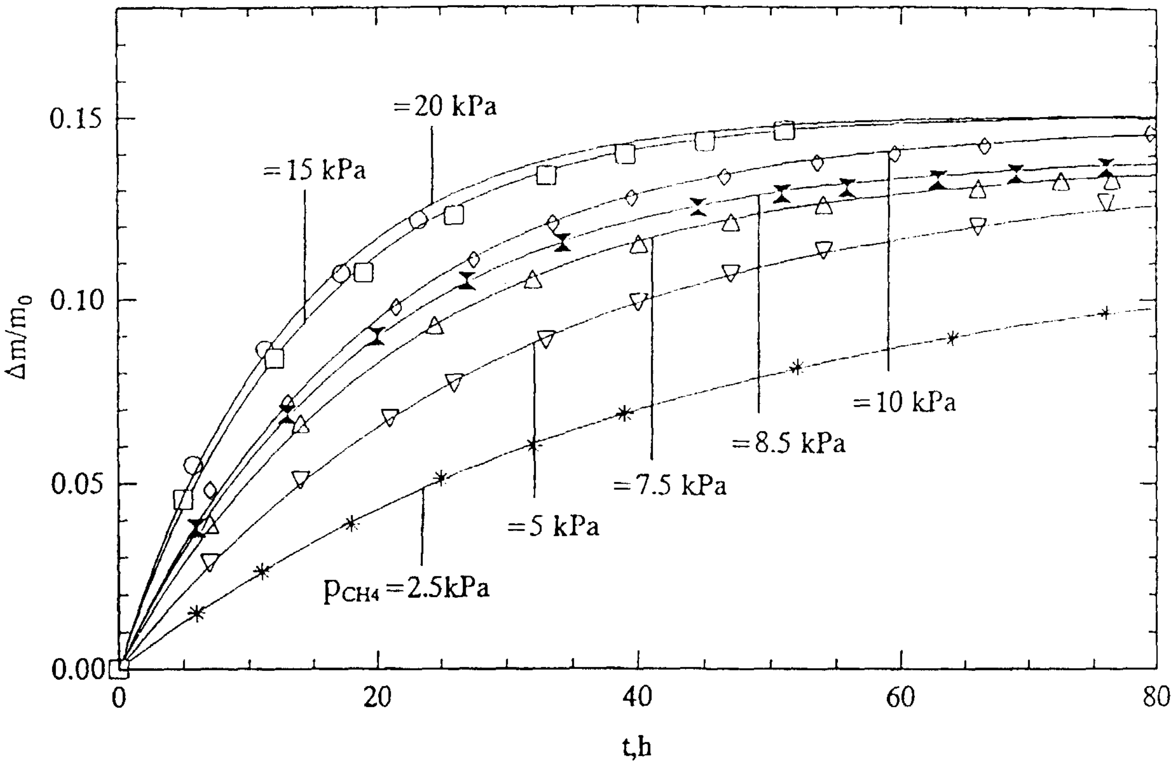
=20 kPa
=15 kPa
=10 kPa
=8.5 kPa
=7.5 kPa
=5 kPa
$p_{CH4}$=2.5kPa
0.15
0.10
0.05
0.00
Δm/m₀
0
20
40
60
80
t,h

Fig. 6

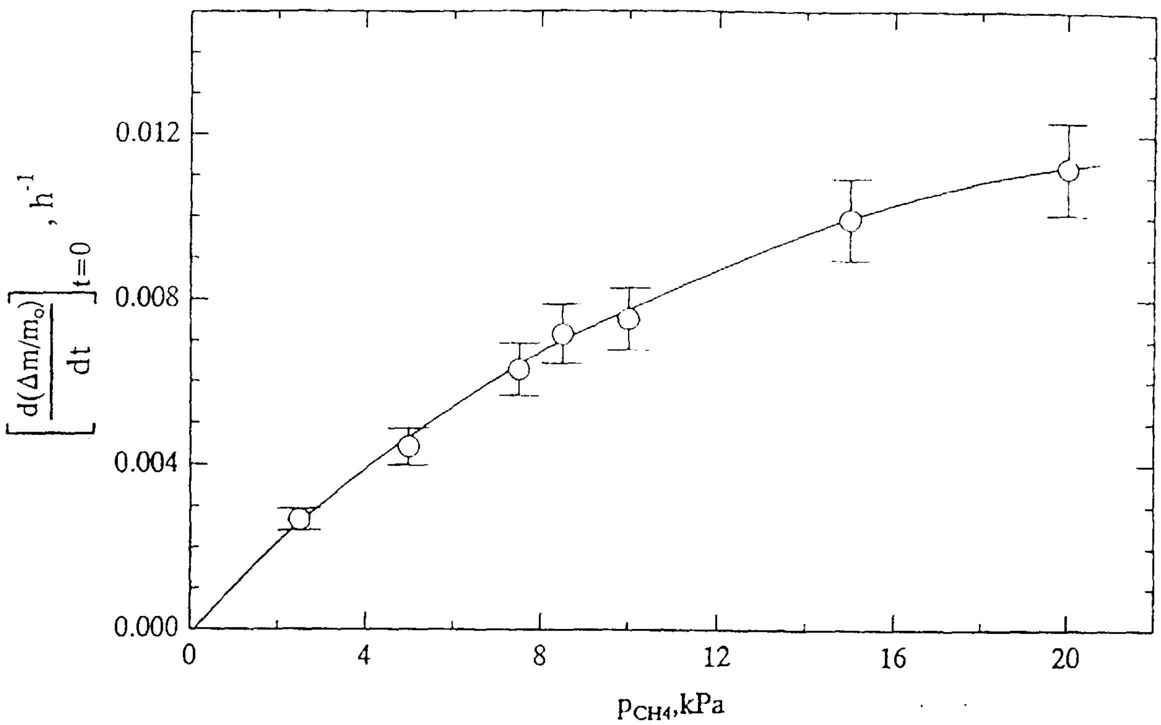


Fig. 7

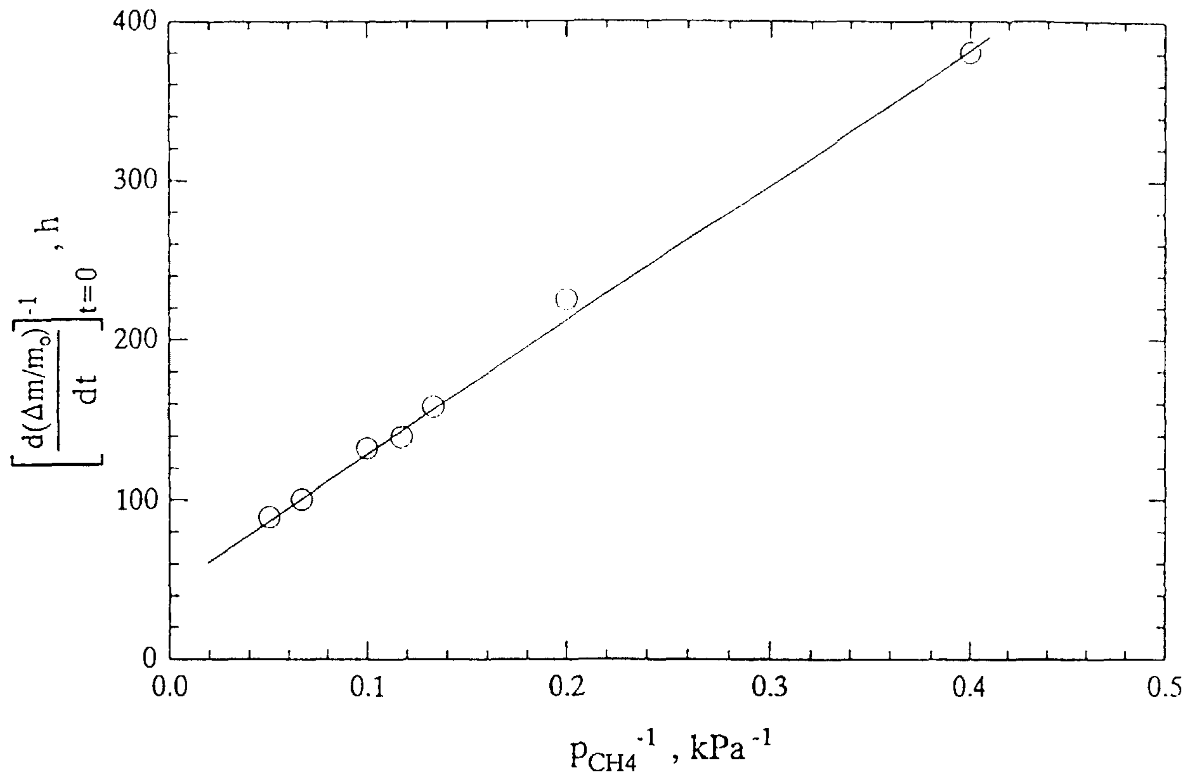
400
300
200
100
0
0.0
0.1
0.2
0.3
0.4
0.5
$\left[\frac{d(\Delta m/m_o)}{dt}\right]^{-1}_{t=0}$, h
$p_{CH4}^{-1}$, kPa$^{-1}$

Fig. 8

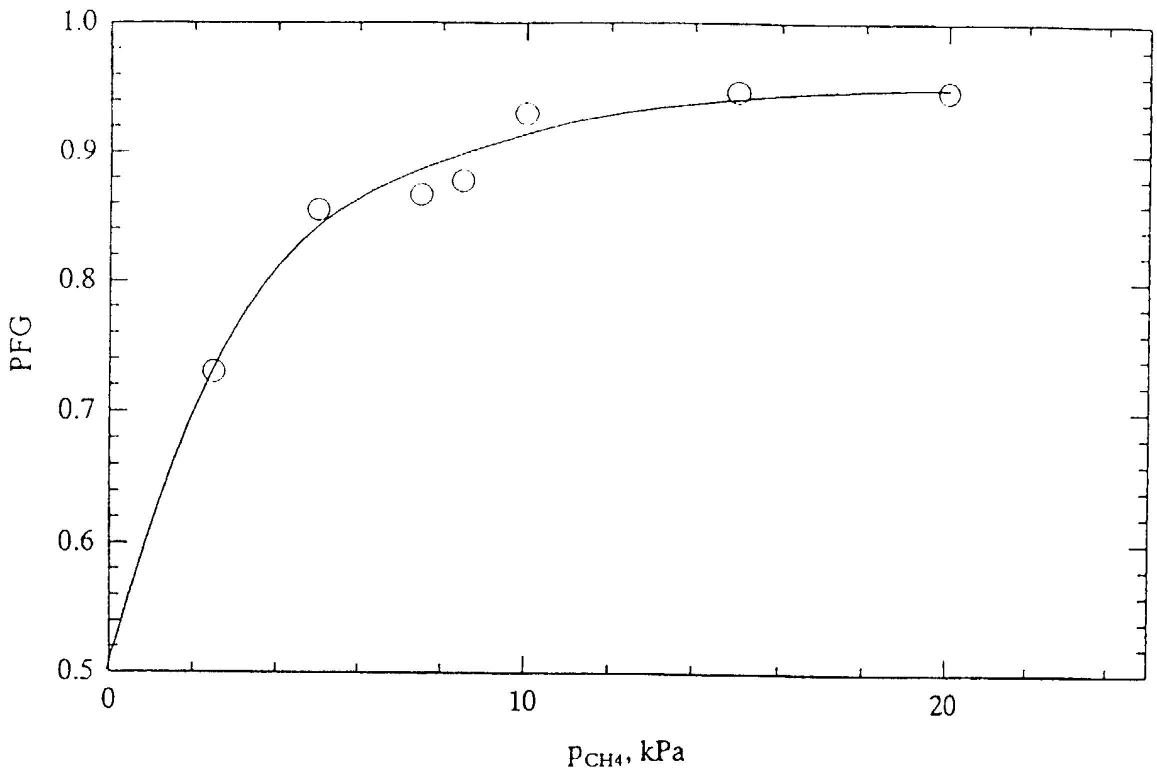


Fig. 9

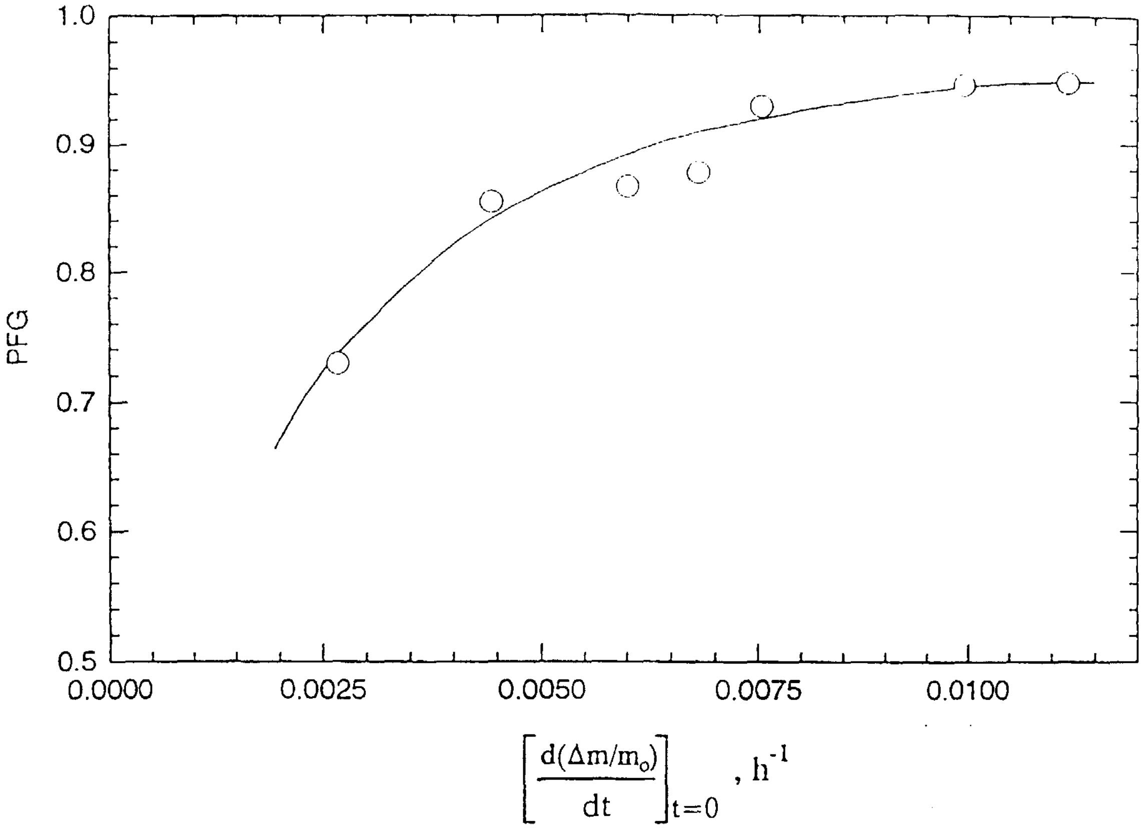
1.0
0.9
0.8
0.7
0.6
0.5
PFG
0.0000
0.0025
0.0050
0.0075
0.0100
[d(Δm/m_o)/dt]_{t=0} , h^-1

Fig. 10

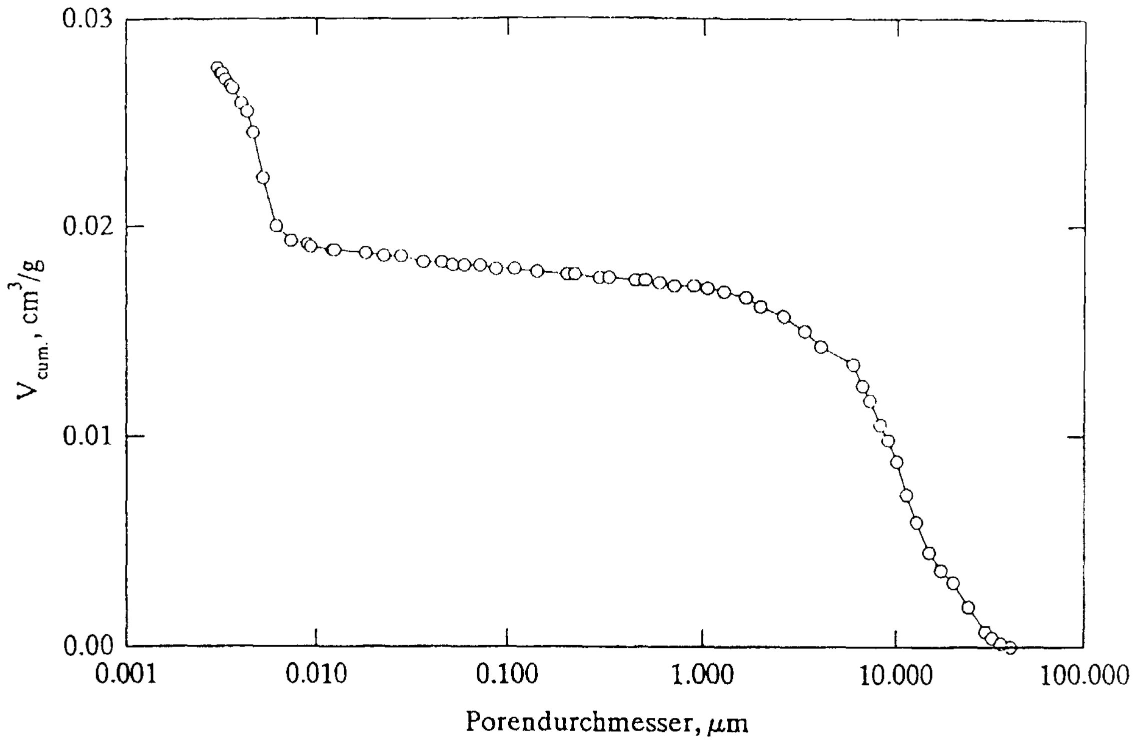
0.03
0.02
0.01
0.00
0.001
0.010
0.100
1.000
10.000
100.000
Porendurchmesser, μm
V cum., cm3/g

Fig. 11A

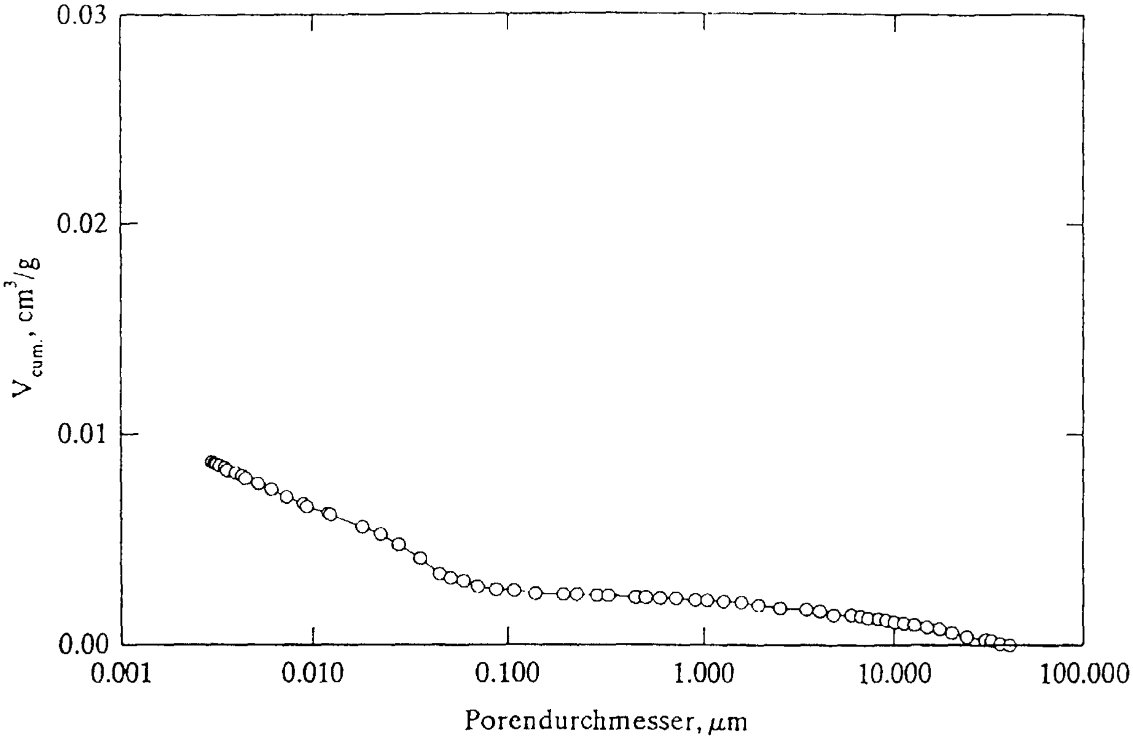
0.03
0.02
0.01
0.00
$V_{cum.}$, $cm^3/g$
0.001
0.010
0.100
1.000
10.000
100.000
Porendurchmesser, μm

Fig. 11B

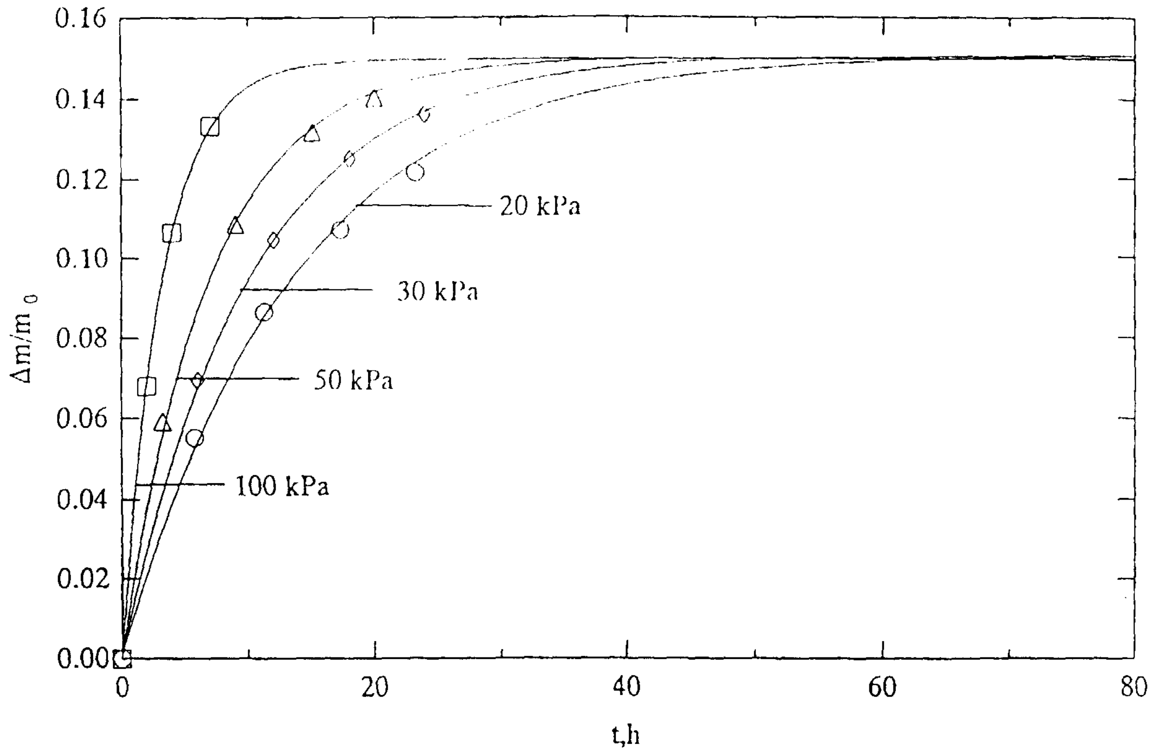
0.16
0.14
0.12
0.10
0.08
0.06
0.04
0.02
0.00
Δm/m 0
20 kPa
30 kPa
50 kPa
100 kPa
0
20
40
60
80
t,h

Fig. 12

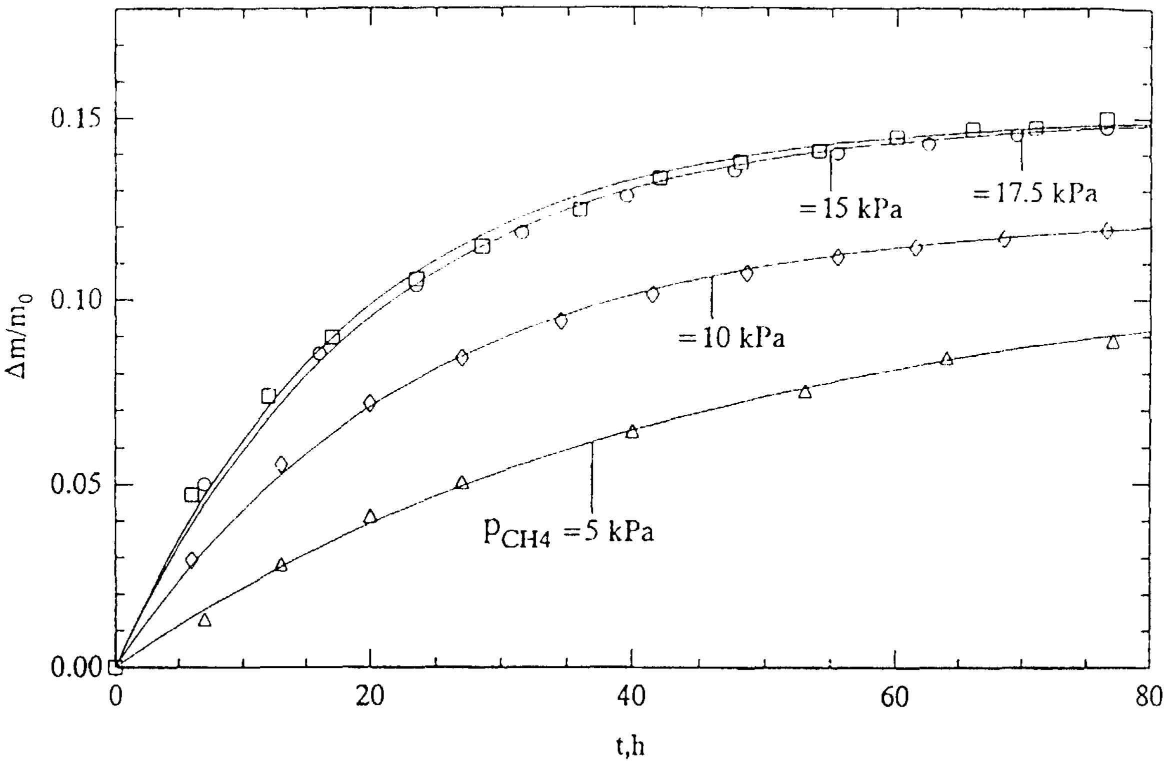
0.15
0.10
0.05
0.00
Δm/m0
0
20
40
60
80
t,h
=15 kPa
=17.5 kPa
=10 kPa
PCH4 =5 kPa

Fig. 13

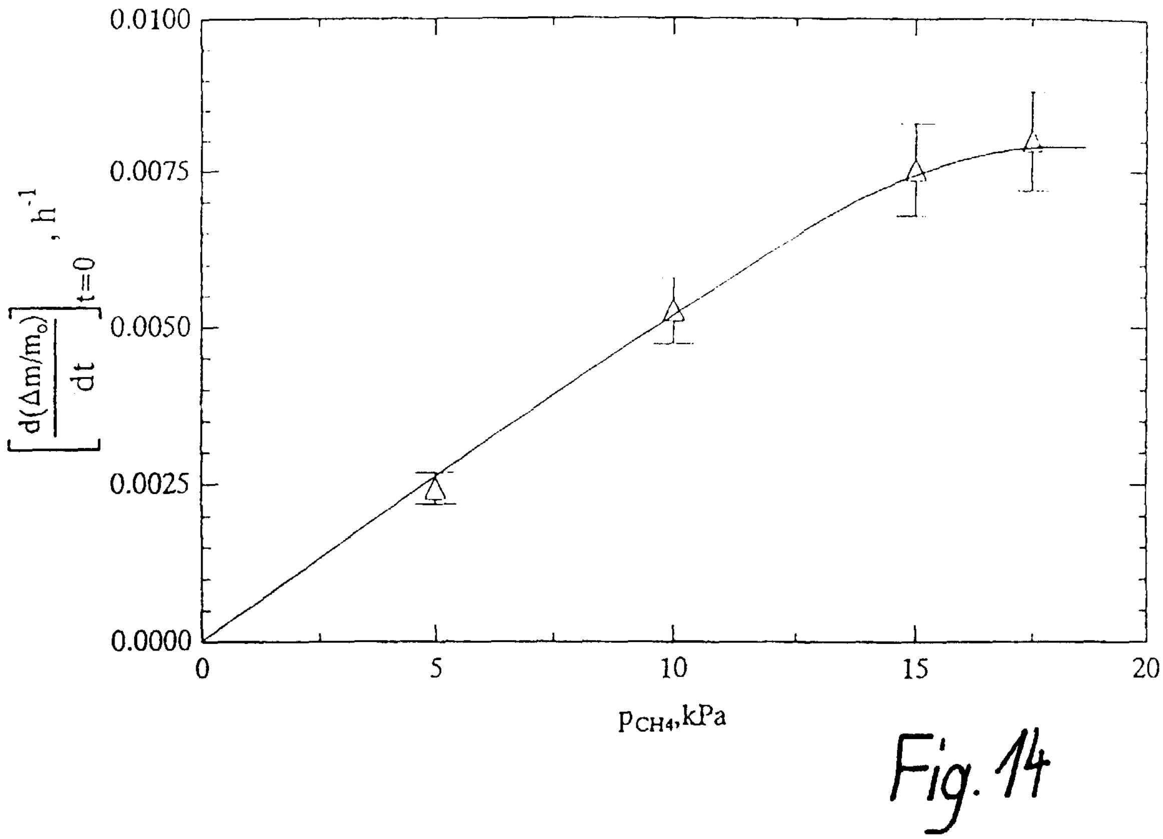
0.0100
0.0075
0.0050
0.0025
0.0000
0
5
10
15
20
$\left[\frac{d(\Delta m/m_o)}{dt}\right]_{t=0}$, $h^{-1}$
$p_{CH_4}$,kPa

Fig. 14

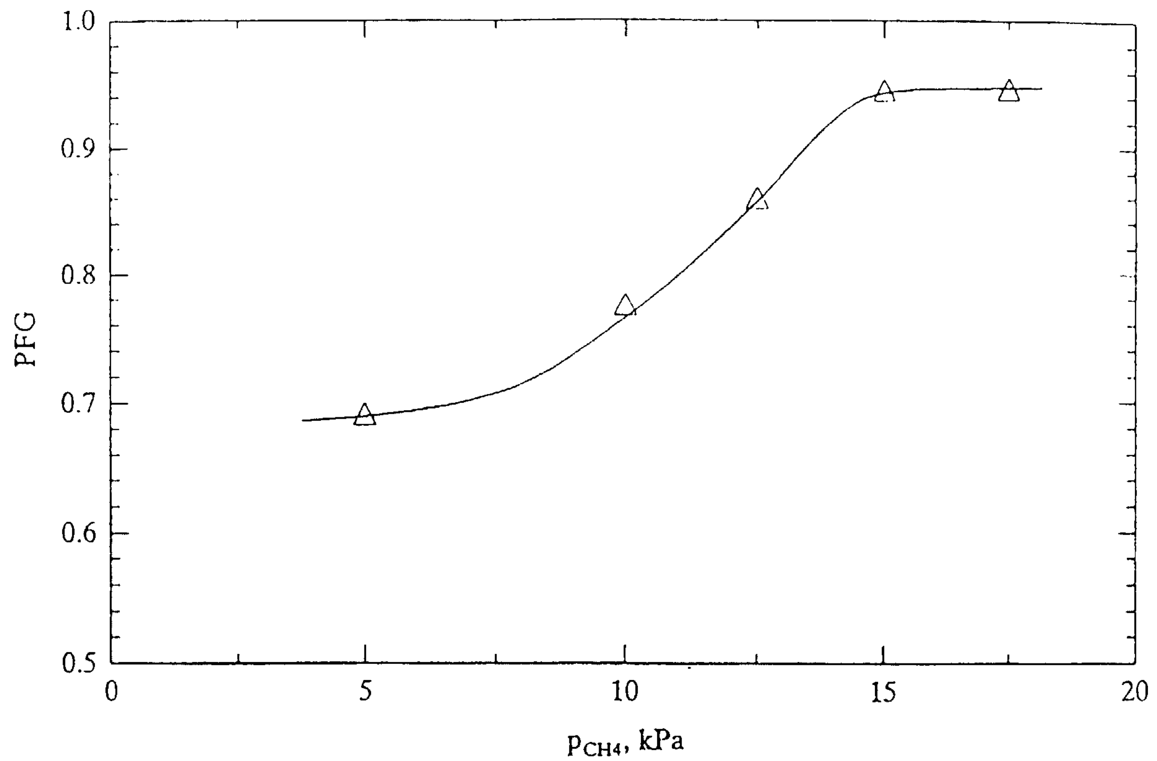


Fig. 15

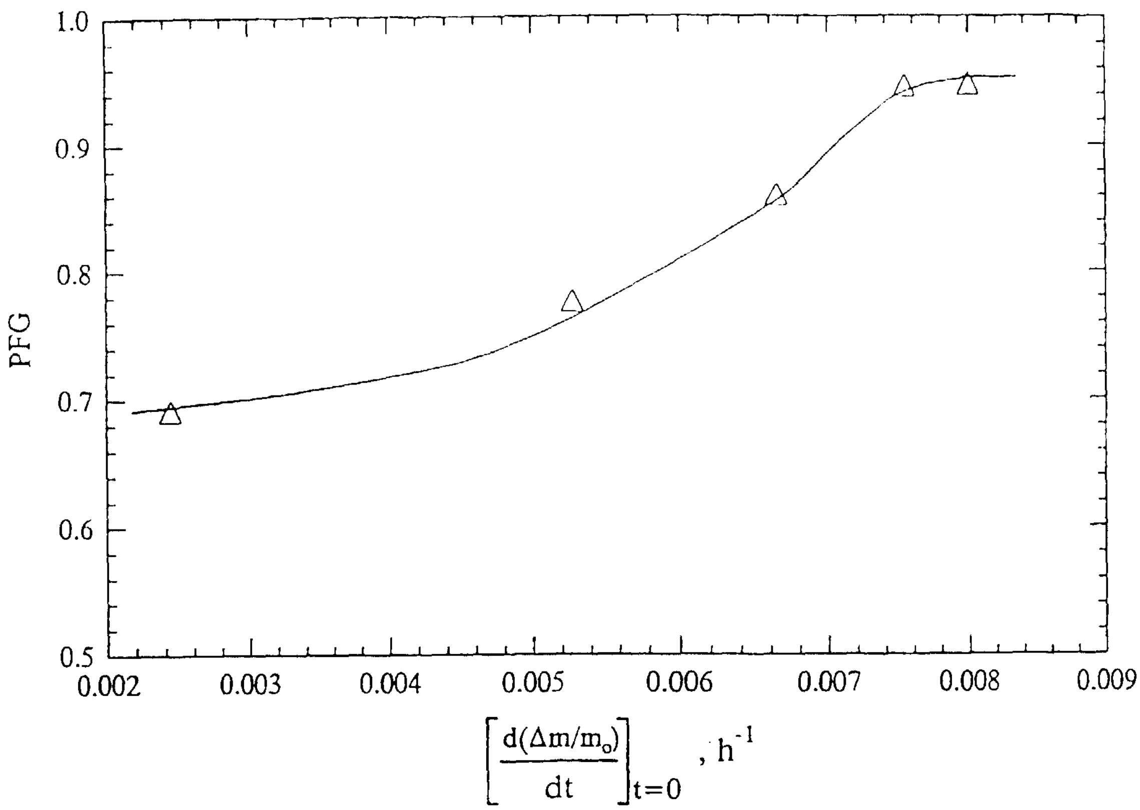
1.0
0.9
0.8
0.7
0.6
0.5
PFG
0.002
0.003
0.004
0.005
0.006
0.007
0.008
0.009
$\left[\frac{d(\Delta m/m_o)}{dt}\right]_{t=0}$ , $h^{-1}$

Fig. 16

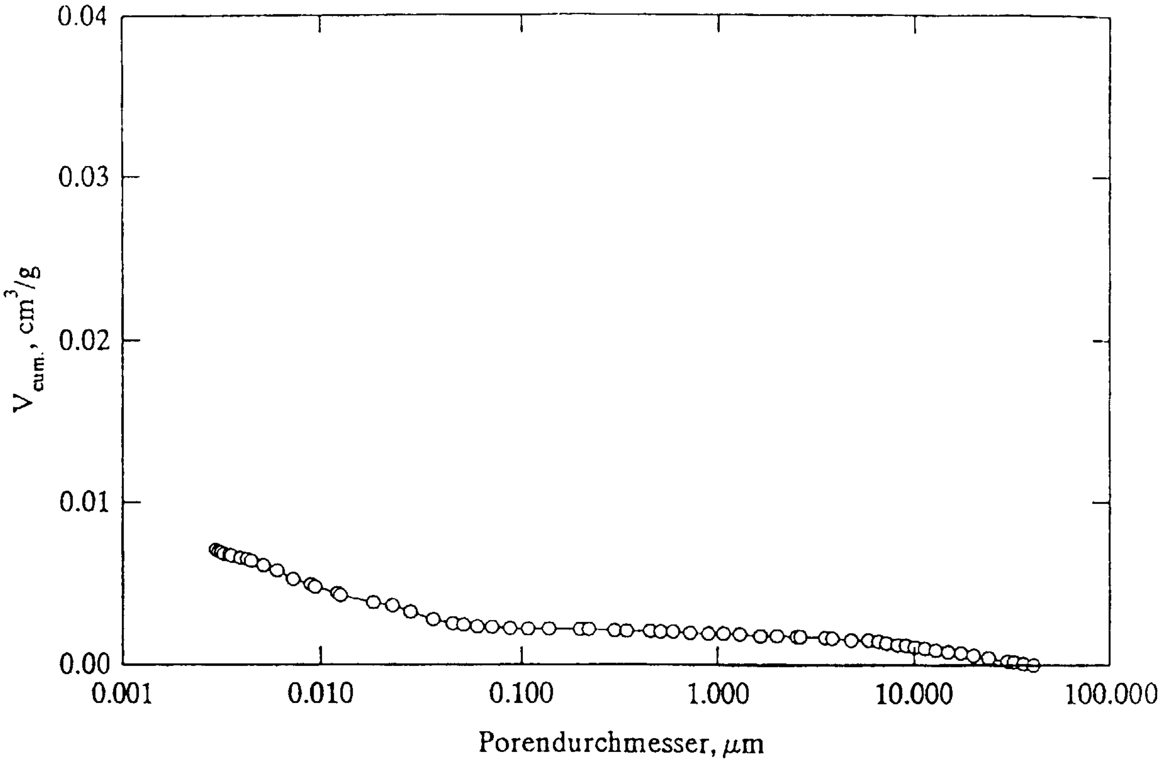
0.04
0.03
0.02
0.01
0.00
$V_{cum.}$, $cm^3/g$
0.001
0.010
0.100
1.000
10.000
100.000
Porendurchmesser, $\mu m$

Fig. 17

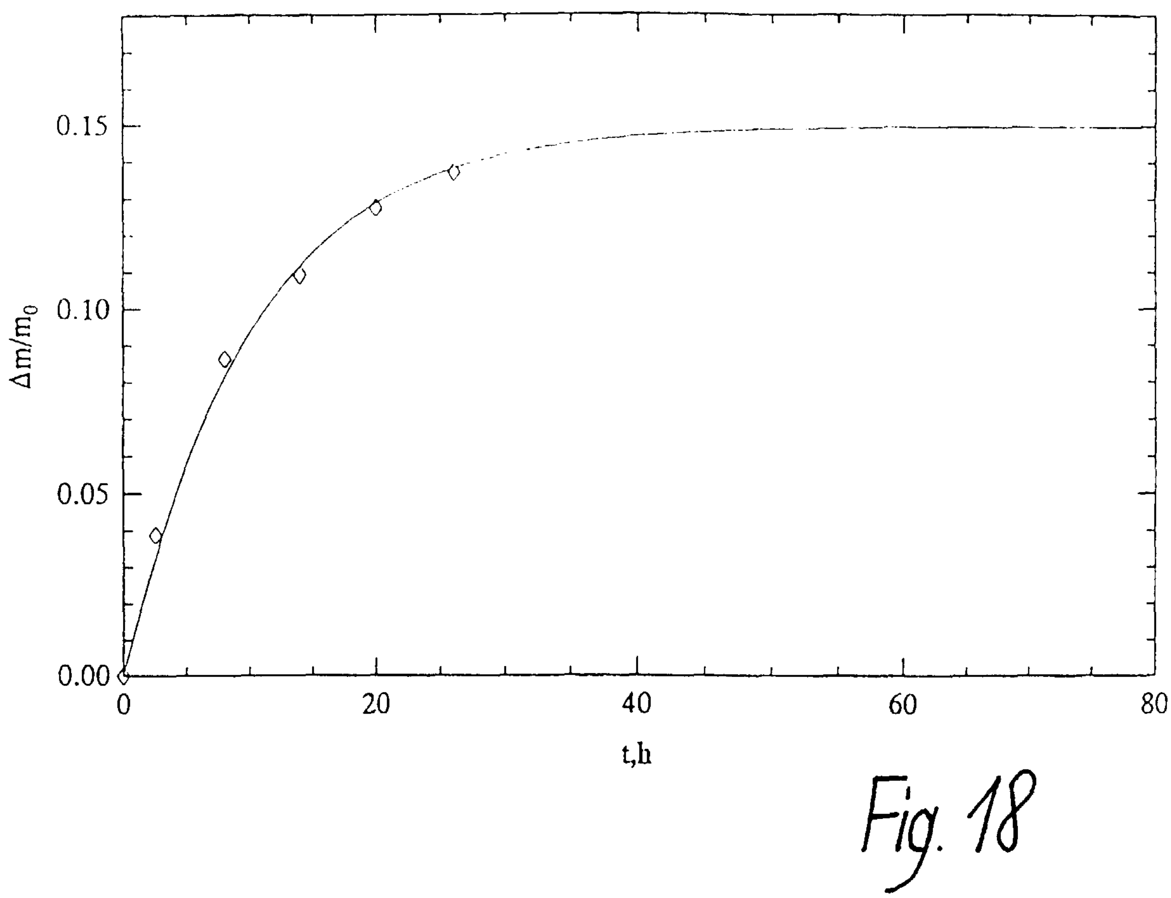


Fig. 18

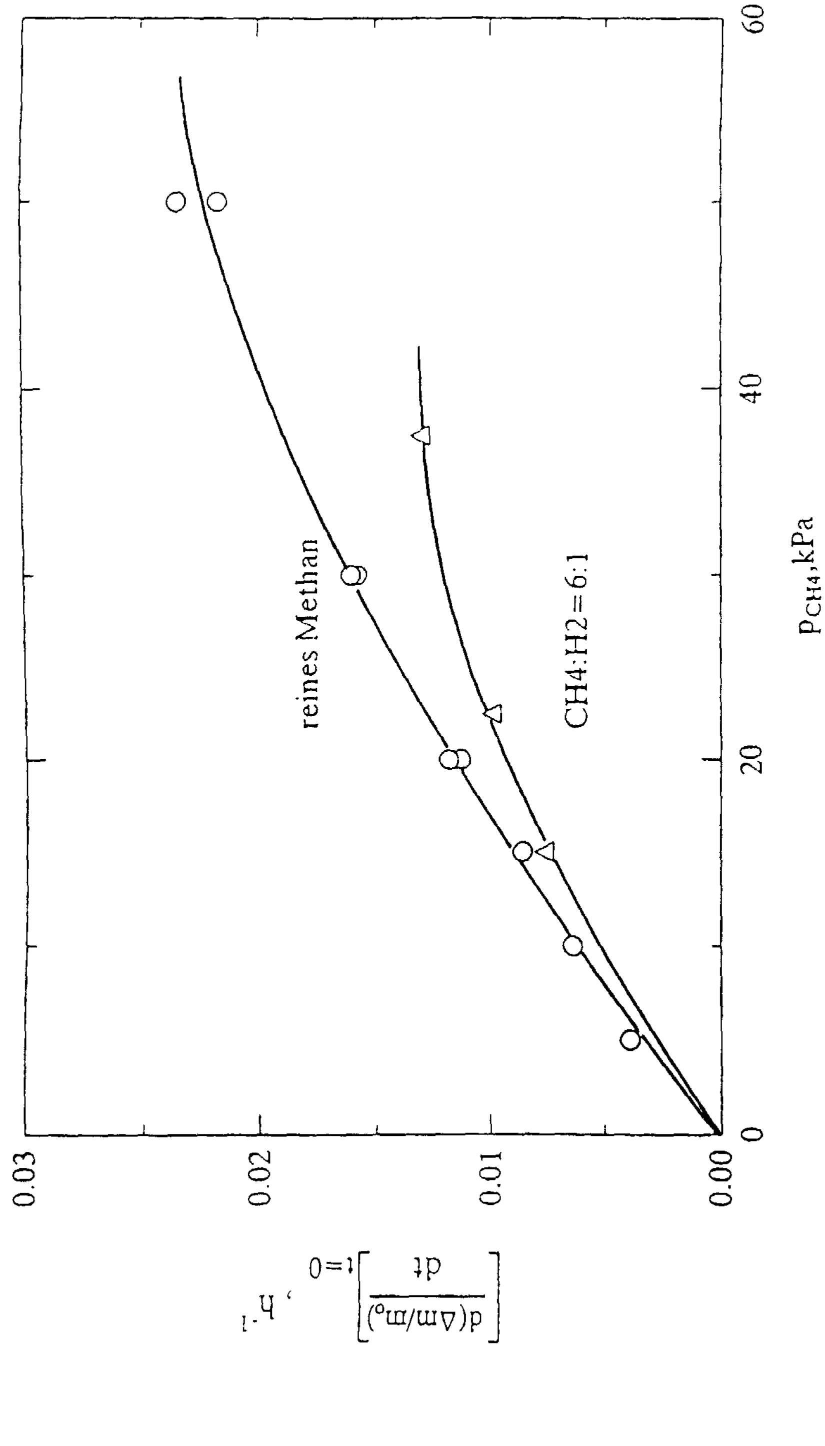
0.03
0.02
0.01
0.00
0
20
40
60
reines Methan
CH4:H2=6:1
PCH4,kPa
d(Δm/mo) / dt t=0, h-1

Fig. 19